(19) **Europäisches Patentamt / European Patent Office / Office européen des brevets**

(11) **EP 4 624 333 A1**

(12) **EUROPEAN PATENT APPLICATION**
published in accordance with Art. 153(4) EPC

(43) Date of publication:
01.10.2025 Bulletin 2025/40

(51) International Patent Classification (IPC):
*B64D 27/24* (2024.01)    *B64U 50/30* (2023.01)
*H01M 10/44* (2006.01)    *H01M 10/48* (2006.01)

(21) Application number: 23894285.8

(22) Date of filing: 11.10.2023

(52) Cooperative Patent Classification (CPC):
**B60L 58/16; B60L 3/0046; B60L 58/12;
B60L 58/13; B64D 27/24; B64D 27/34;
B64D 27/357; B64D 31/16; B64U 50/19;
B64U 50/30; H01M 10/44; H01M 10/48;**
B60L 2200/10; B60L 2240/545; B64D 2045/0085;
(Cont.)

(86) International application number:
**PCT/JP2023/036828**

(87) International publication number:
**WO 2024/111273 (30.05.2024 Gazette 2024/22)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 25.11.2022 JP 2022188620

(71) Applicant: **DENSO CORPORATION**
Kariya-city, Aichi 448-8661 (JP)

(72) Inventors:
• **NAKAMURA, Masaya**
Kariya- city Aichi 4488661 (JP)
• **YOSHIDA, Shuhei**
Kariya- city Aichi 4488661 (JP)

(74) Representative: **TBK**
Bavariaring 4-6
80336 München (DE)

(54) **MONITORING DEVICE, CONTROL DEVICE, OPERATION MANAGEMENT SYSTEM, AND PROGRAM**

(57)    A monitor (50) is configured to monitor a state of a battery (151) mounted on an eVTOL. The monitor (50) includes: an acquisition unit (51) configured to acquire information regarding the battery (151); a calculation unit (52) configured to calculate, based on the information, a degree of temporary deterioration caused by an imbalance in ion concentration of the battery (151); and an output unit (54) configured to output information regarding the degree of temporary deterioration. According to the monitor (50), since the degree of temporary deterioration can be grasped, the flight safety can be enhanced.

FIG. 4

EP 4 624 333 A1

(52) Cooperative Patent Classification (CPC): (Cont.)
     B64D 2221/00

## Description

CROSS REFERENCE TO RELATED APPLICATION

This application is based on Japanese Patent Application No. 2022-188620 filed on November 25, 2022, the disclosure of which is incorporated herein by reference.

TECHNICAL FIELD

The present disclosure relates to a monitor, a controller, an operation management system, and a program.

BACKGROUND ART

Patent Document 1 discloses an electric aircraft. The disclosure of prior art literature is incorporated herein by reference as description of technical elements.

PRIOR ART LITERATURES

PATENT LITERATURE

Patent Document 1 : JP 2020-196440 A

SUMMARY OF INVENTION

A battery mounted on an electric aircraft is likely to cause a temporary (reversible) rise in internal resistance of the battery, that is, temporary deterioration caused by an imbalance in ion concentration distribution due to a high-output load specific to the electric aircraft. For example, as disclosed in Patent Document 1, even if plural batteries are provided to provide redundancy, temporary deterioration may occur simultaneously in the batteries. That is, there is a possibility that the redundancy of the batteries can no longer be secured. From the above viewpoint or from another viewpoint not mentioned, further improvement is required for a monitor, a controller, an operation management system, and a program.

An object of the disclosure is to provide a monitor, a controller, an operation management system, and a program that can enhance flight safety.

A disclosed monitor is configured to monitor a state of a battery mounted on an electric aircraft, and includes:

an acquisition unit configured to acquire information regarding the battery;
a calculation unit configured to calculate, based on the information, a degree of temporary deterioration caused by an imbalance in ion concentration of the battery; and
an output unit configured to output information regarding the degree of temporary deterioration.

According to the monitor of the disclosure, the degree of temporary deterioration can be grasped based on information regarding the battery. This enables appropriate processing leading to flight safety, for example, flight control and maintenance. Therefore, the flight safety can be enhanced.

A disclosed controller for an electric aircraft that drives a drive target including a rotor blade by a plurality of batteries includes:

an acquisition unit configured to acquire information regarding a degree of temporary deterioration caused by an imbalance in ion concentration of the batteries; and
a control unit configured to control discharge and/or charge of the batteries based on the degree of temporary deterioration.

According to the controller of the disclosure, discharge and/or charge of the battery is controlled after the degree of temporary deterioration is grasped. Therefore, appropriate control leading to flight safety can be executed. Therefore, the flight safety can be enhanced.

A disclosed operation management system for an electric aircraft includes:

a monitor configured to acquire information regarding a battery mounted on the electric aircraft and calculate a degree of temporary deterioration caused by an imbalance in ion concentration of the battery; and
a controller configured to control discharge and/or charge of the battery based on the degree of temporary deterioration.

According to the operation management system of the disclosure, the degree of temporary deterioration can be monitored, and discharge and/or charge of the battery can be controlled based on this monitoring result. Therefore, appropriate control leading to flight safety can be executed. Therefore, the flight safety can be enhanced.

A disclosed program for monitoring a state of a battery mounted on an electric aircraft includes:

causing at least one processing unit
to acquire information regarding the battery, and
to calculate a degree of temporary deterioration caused by an imbalance in ion concentration of the battery based on the information.

According to the program of the disclosure, the degree of temporary deterioration can be grasped based on information regarding the battery. This enables appropriate processing leading to flight safety, for example, flight control and maintenance. Therefore, the flight safety can be enhanced.

A disclosed program for controlling a battery mounted on an electric aircraft includes:

causing at least one processing unit
to acquire information regarding a degree of temporary deterioration caused by an imbalance in ion concentration of the battery, and
to control discharge and/or charge of the battery based on the degree of temporary deterioration.

According to the program of the disclosure, discharge and/or charge of the battery can be controlled after the degree of temporary deterioration is grasped. Therefore, appropriate control leading to flight safety can be executed. Therefore, the flight safety can be enhanced.

Plural aspects disclosed in this description employ technical means different from one another for achieving respective objectives. Reference signs in parentheses in the claims exemplarily indicate a correspondence relationship with parts of the embodiments described later, and are not intended to limit the technical scope. The objects, features, and effects disclosed in this description will become more apparent by reference to the detailed description described later and the accompanying drawings.

BRIEF DESCRIPTION OF DRAWINGS

FIG. 1 is a view illustrating a power profile of an eVTOL.
FIG. 2 is a view illustrating configurations of the eVTOL and a ground station.
FIG. 3 is a view illustrating a functional arrangement of an operation management system in a first embodiment.
FIG. 4 is a view illustrating a schematic configuration of a monitor and the operation management system.
FIG. 5 is a flowchart showing an example of an operation management method.
FIG. 6 is a flowchart showing an example of a monitoring method.
FIG. 7 is a view showing an execution timing of monitoring processing.
FIG. 8 is a view showing a modification.
FIG. 9 is a view illustrating a schematic configuration of an operation management system in a second embodiment.
FIG. 10 is a view illustrating a restraint state of a battery cell.
FIG. 11 is a flowchart showing an example of a control method.
FIG. 12 is a flowchart showing a modification of recovery control.
FIG. 13 is a view illustrating a configuration example of a battery system in a third embodiment.
FIG. 14 is a view illustrating another configuration example of the battery system.
FIG. 15 is a view illustrating another configuration example of the battery system.
FIG. 16 is a view illustrating effects by a combination of recovery controls.
FIG. 17 is a view showing functions of charge-related equipment.
FIG. 18 is a view illustrating an example of a charge method.
FIG. 19 is a view illustrating an example of a charge method.
FIG. 20 is a view illustrating a modification.

DESCRIPTION OF EMBODIMENTS

Hereinafter, embodiments will be described with reference to the drawings. The same reference signs are given to corresponding constituent elements in each embodiment, and redundant description may be omitted. When only a part of the configuration is described in each embodiment, other parts of the configuration can be applied with the configuration of the other embodiments described previously. Not only a combination of configurations explicitly described in the description of each embodiment but also configurations of the embodiments can be partially combined even if not explicitly described as long as there is no problem in the combination.

A monitor, a controller, an operation management system, a program, and a battery system presented below are applied to an electric aircraft.

(First Embodiment)

An electric aircraft includes a motor (rotating electrical machine) as a drive source for movement. The electric aircraft may be called an electric airplane, an electric plane, or the like. The electric aircraft can move vertically and horizontally. The electric aircraft can move in a direction having a vertical component and a horizontal component, that is, an oblique direction. The electric aircraft is, for example, an electronic vertical take-off and landing aircraft (eVTOL), an electronic short distance take-off and landing aircraft (eSTOL), a drone, or the like. eVTOL is an abbreviation for electronic vertical take-off and Landing aircraft. eSTOL is an abbreviation for electronic short distance take-off and landing aircraft.

The electric aircraft may be either a manned vehicle or an unmanned vehicle. In the case of a manned aircraft, the electric aircraft is operated by a pilot as an operator. In the case of an unmanned vehicle, the electric aircraft can be operated by remote control by an operator or automatically controlled by a control system. As an example, the electric aircraft of the present embodiment is an eVTOL.

<Power Profile>

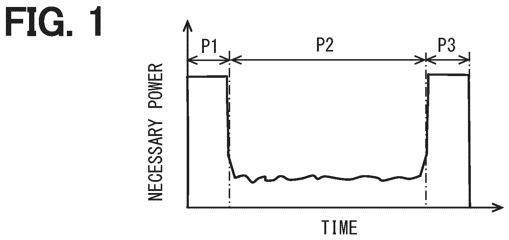

FIG. 1 illustrates a power profile of the eVTOL from takeoff to landing. The power profile of an electric aircraft other than the eVTOL is similar to that of the eVTOL. A period P1 is called a takeoff period, a takeoff time, a departure period, a departure time, and the like. A period P2 is called a cruise period, a cruise time, or the like. A period P3 is called a landing period, a landing time, an arrival period, an arrival time, and the like. For the sake of convenience, in FIG. 1, necessary power, that is, output is made constant in substantially the entire region of each of the periods P1 and P3.

The eVTOL ascends from a takeoff point to a cruise start point in the period P1. The eVTOL cruises at a predetermined altitude in the period P2. The eVTOL descends to a landing point from the end point of the period P2 in the period P3. Movement of the eVTOL mainly includes a horizontal component in the period P2, and mainly includes a vertical component in the periods P1 and P3. In the periods P1 and P3 in which the eVTOL moves vertically, drive of rotor blades of the eVTOL requires high output continuously for a predetermined time.

<Temporary Deterioration of Battery>

When a secondary battery is output, that is, discharged, a temporary imbalance occurs in the concentration distribution of ions contributing to the battery reaction. The concentration imbalance occurs in the electrolytic solution or the electrode. When the concentration imbalance occurs, the internal resistance of the battery temporarily (reversibly) rises. Therefore, even when the SOC of the battery is sufficient, the output performance of the battery decreases. In this manner, temporary (reversible) deterioration occurs in the battery. The temporary deterioration may be called high-rate deterioration. The SOC is an abbreviation for state of charge.

The greater the concentration imbalance is, the more the degree of temporary deterioration increases. In particular, high output or continuous output increases the degree of temporary deterioration. As illustrated in FIG. 1, in the eVTOL, high output is required at the time of takeoff and at the time of landing. Continuous output is required during navigation. Therefore, the degree of temporary deterioration is likely to increase.

When the degree of temporary deterioration increases, there is a possibility that high output characteristics required for takeoff and landing cannot be exhibited. That is, there is a possibility of decreasing the flight safety. Assuming that an abnormality occurs in the battery, it is very important to increase safety by providing redundancy. However, temporary deterioration can occur simultaneously in plural batteries. Therefore, there is a possibility that the redundancy of the battery cannot be secured.

The temporary deterioration of the battery is not permanent abnormality or deterioration that cannot be recovered, such as disconnection abnormality or battery capacity deterioration, but is temporary deterioration that can be eliminated. Therefore, it is desired to eliminate/reduce temporary deterioration in advance.

<eVTOL>

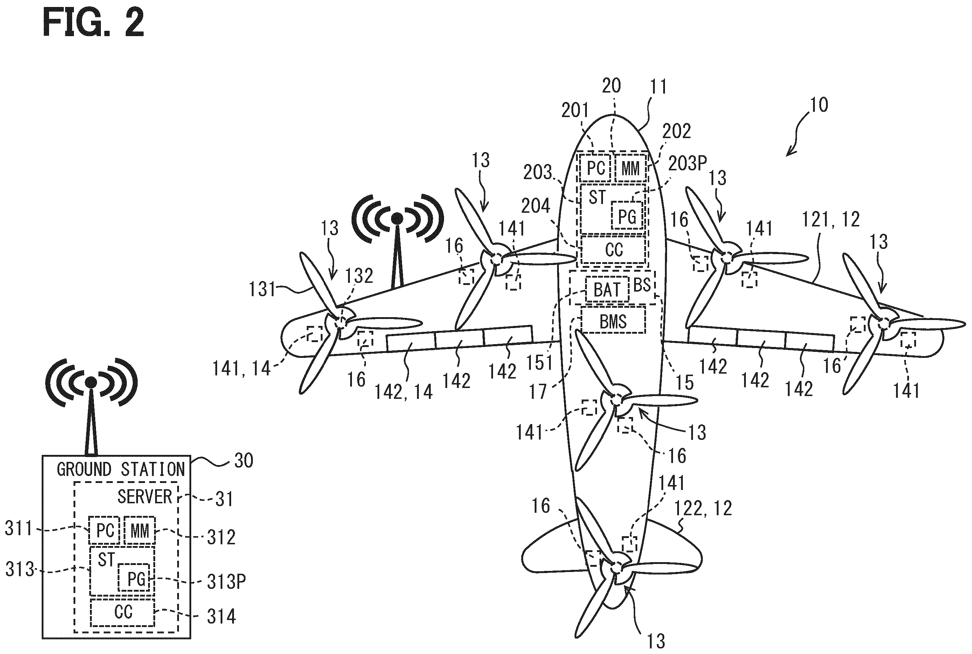

FIG. 2 illustrates an eVTOL and a ground station. As illustrated in FIG. 2, an eVTOL 10 includes a fuselage 11, a fixed wing 12, a rotor blade 13, a lift adjustment mechanism 14, a battery system 15, an EPU 16, and BMS 17.

The fuselage 11 is a body portion of an airframe. The fuselage 11 has a shape extending forward and backward. The fuselage 11 has a passenger compartment for a passenger to ride and/or a luggage compartment for mounting luggage.

The fixed wing 12 is a blade portion of the airframe and is continuous to the fuselage 11. The fixed wing 12 provides gliding lift. The gliding lift is the lift generated by the fixed wing 12. As an example, the fixed wing 12 includes a main wing 121 and an empennage 122. The main wing 121 extends left and right from near the center in the front-rear direction of the fuselage 11. The empennage 122 extends left and right from the rear portion of the fuselage 11. The shape of the fixed wing 12 is not particularly limited. For example, a backward blade, a triangular blade, a straight blade, or the like can be employed.

Plural rotor blades 13 are provided in the airframe. At least a part of the rotor blades 13 may be provided in the fixed wing 12. At least a part of the rotor blades 13 may be provided in the fuselage 11. The number of rotor blade 13 included in the eVTOL 10 is not particularly limited. As an example, plural rotor blades 13 are provided in each of the fuselage 11 and the main wing 121. The eVTOL 10 includes six rotor blades 13.

The rotor blade 13 may be called a rotor, a propeller, a fan, or the like. The rotor blade 13 includes a blade 131 and a shaft 132. The blade 131 is attached to the shaft 132. The blade 131 is a blade that rotates together with the shaft 132. Plural blades 131 extend radially about the axis of the shaft 132. The shaft 132 is a rotation axis of the rotor blade 13, and is rotationally driven by a motor of the EPU 16.

The rotor blade 13 generates a propulsive force by rotation. The propulsive force acts on the eVTOL 10 mainly as rotary lift at takeoff and landing times of the eVTOL 10. The rotor blade 13 mainly provides rotary lift at takeoff and landing times. The rotary lift is lift generated by rotation of the rotor blade 13. At takeoff and landing times, the rotor blade 13 may provide only rotary lift, or may provide forward thrust together with rotary lift. The rotor blade 13 provides rotary lift at a hovering time of the eVTOL 10.

The propulsive force acts on the eVTOL 10 mainly as thrust at a cruise time of the eVTOL 10. The rotor blade 13 mainly provides thrust at a cruise time. At a cruise time, the rotor blade 13 may provide only thrust or may provide lift along with thrust.

The lift adjustment mechanism 14 adjusts gliding lift of the fixed wing 12. The lift adjustment mechanism 14 increases or decreases the gliding lift generated by the fixed wing 12. The lift adjustment mechanism 14 adjusts the gliding lift by, for example, adjusting at least one of the surface area of the fixed wing 12, the angle of attack (AOA), the camber (curvature of the wing), the stalling AOA, and the wing velocity. AOA is an abbreviation for angle of attack. As an example, the lift adjustment mechanism 14 includes a tilt mechanism 141 and a flap 142.

The tilt mechanism 141 is driven to adjust the tilt angle of the rotor blade 13. The tilt mechanism 141 constitutes a tilt adjustment device together with a motor, an inverter, and the like that drive the tilt mechanism 141. The tilt adjustment device including the tilt mechanism 141 is individually provided for the rotor blade 13, for example. The tilt mechanism 141 adjusts the tilt angle of the rotor blade 13 by adjusting the relative inclination of the rotor blade 13 with respect to the airframe.

At takeoff and landing times, the tilt mechanism 141 controls the tilt angle so that the axis of each rotor blade 13 approaches a position parallel to the vertical direction. By this, the propulsive force by rotation of each rotor blade 13 acts on the eVTOL 10 mainly as rotary lift. Therefore, the eVTOL 10 can perform takeoff and landing at a short distance or takeoff and landing in the vertical direction.

At a cruise time, the tilt mechanism 141 controls the tilt angle so that the axis of each rotor blade 13 approaches a position parallel to the horizontal direction. By this, the propulsive force by rotation of each rotor blade 13 acts on the eVTOL 10 mainly as thrust. Therefore, the eVTOL 10 can move forward by the forward thrust by the rotation of each rotor blade 13 while obtaining the gliding lift by the fixed wing 12. The gliding lift can be adjusted by changing a wing velocity V by the thrust.

While an example of individually providing the tilt mechanism 141 to the rotor blade 13 has been described, it is not limited to this. For example, the tilt angle of the rotor blades 13 arranged side by side may be controlled by a common tilt mechanism. The rotor blade 13 may be configured to be integrated with a part of the blade portion, and the part of the blade portion and the rotor blade 13 may be configured to be integrally displaced by the tilt mechanism.

The flap 142 is a movable blade piece and is provided on the fixed wing 12. The flap 142 constitutes a flap adjustment device together with a motor, an inverter, and the like that drive the flap 142. The flap 142 may be called a high lift device. As an example, the plural flaps 142 are provided at the rear edge of the main wing 121. Each of the flaps 142 is provided with a motor and an inverter. The flap 142 may be provided on the empennage 122 in addition to the main wing 121. The flap 142 may be provided at a front edge of the fixed wing 12.

The flap 142 adjusts the surface area and camber of the fixed wing 12. For example, by controlling the flap 142 provided on the main wing 121 to a lower position, the gliding lift acting on the main wing 121 increases. In addition, by moving the flap 142 in a direction protruding from the main wing 121, it is possible to further increase the gliding lift.

The lift adjustment mechanism 14 is not limited to the tilt mechanism 141 and the flap 142 described above. As the lift adjustment mechanism 14, a tilt mechanism that adjusts the relative inclination of the fixed wing 12 with respect to the fuselage 11 may be employed. In this case, the angle of attack of the fixed wing 12 can be adjusted. As the lift adjustment mechanism 14, a rotor blade for thrust provided separately from the rotor blade 13 may be employed. In this case, the wing velocity can be adjusted. It is also possible to dedicate the rotor blade 13 to lift (rotary lift) by providing the rotor blade for thrust.

A variable wing may be employed as the lift adjustment mechanism 14. The lift can be adjusted by changing the surface area, the camber, the attachment angle, and the like of the fixed wing 12. As the lift adjustment mechanism 14, a high lift device different from the flap 142, for example, a slat, may be employed. The slat is provided at the front edge of the main wing 121. By moving the slat forward with respect to the main wing 121, it is possible to form a gap between the slat and the main wing 121, and delay peeling. Therefore, the lift can be increased without stalling to a higher angle of attack. That is, stalling AOA can be delayed.

The battery system (BS) 15 at least includes a battery (BAT) 151 that is equipment for rotationally driving the rotor blade 13. A battery 151 can store direct-current power and has a chargeable battery cell. The battery cell is a secondary battery that generates an electromotive voltage by a chemical reaction. The battery cell is, for example, a lithium ion secondary battery, a nickel-metal hydride secondary battery, or the like. The battery cell may be a secondary battery in which an electrolyte is a liquid, or may be what is called an all-solid-state battery in which an electrolyte is a solid. The eVTOL 10 may include a fuel cell and a generator in addition to the battery 151 as a power source that supplies power to the equipment. The battery 151 supplies power to the EPU 16, the tilt adjustment device, the flap adjustment device, and the like. The battery 151 supplies power also to an auxiliary device not illustrated such as an air conditioner, an ECU 20 described later, and the like.

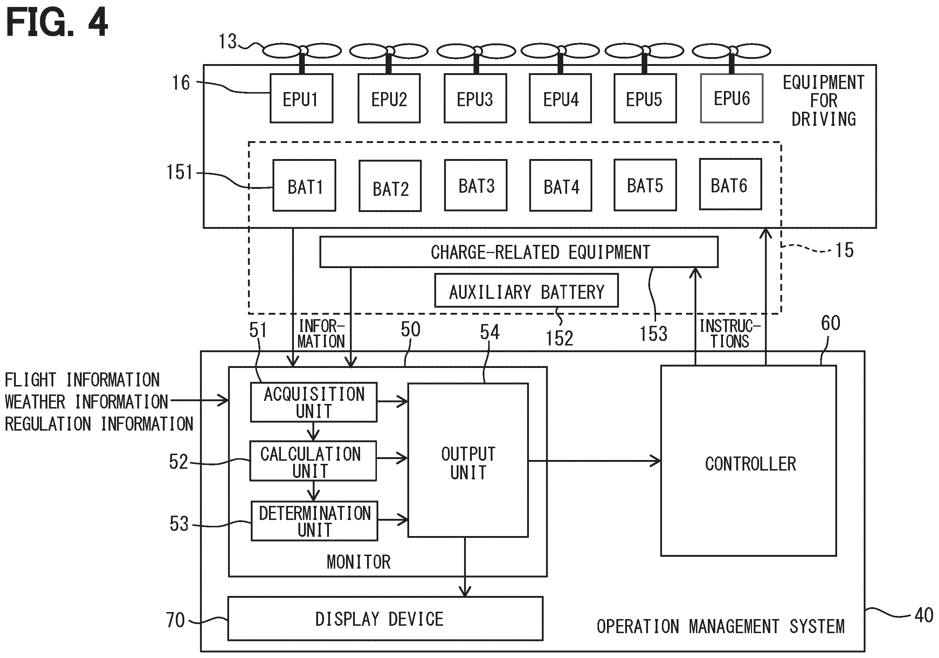

The eVTOL 10 of the present embodiment includes plural batteries 151 (see FIG. 4). The plurality of batteries 151 may be connected to each other in series and/or in parallel, or may be independent without being connected to each other. Each of the batteries 151 has plural battery cells connected in series or plural battery cells connected in parallel and connected in series. The battery 151 is provided as a battery module in which plural battery cells are modularized or a battery pack including a single battery module or plural battery modules. The number and arrangement of the batteries 151 are not particularly limited. As an example, the battery 151 of the present embodiment is provided redundantly with respect to the EPU 16. That is, power can be supplied from the batteries 151 to one EPU 16.

The battery 151 of the eVTOL 10 is required to have high capacity and high output performance. For this reason, a battery cell that can obtain high capacity and high output is desirable. In terms of output, a battery cell having low resistance in a wide SOC region is desirable. In particular, a battery cell having low resistance and high output even in a low SOC region is desirable.

As a positive electrode material of the battery cell, for example, LCO, NMC, NCA, LFP, or LMFP can be employed. LCO is lithium cobalt oxide ($LiCoO_2$). NMC is lithium nickel cobalt manganese oxide ($Li(NiMnCo)O_2$). NCA is lithium nickel cobalt aluminate ($Li(NiCoAl)O_2$). LFP is lithium iron phosphate ($LiFePO_4$). LMFP is lithium manganese iron phosphate ($LiFe_xMn_yPO_4$). In particular, a positive electrode of LMFP or a positive electrode in which LMFP and NMC are blended, which has low resistance in a low SOC region, is preferable.

As a negative electrode material of the battery cell, for example, carbon-based materials such as hard carbon and soft carbon, silicon, lithium-based materials, and titanium-based materials such as LTO and NTO can be employed. LTO is lithium titanate ($Li_4Ti_5O_{12}$). NTO is niobium titanium oxide ($TiNb_2O_7$). In particular, a carbon-based negative electrode or a titanium-based negative electrode, which has low resistance in a low SOC region, is preferable.

The battery system 15 may include only the batteries 151 or may include equipment related to charge and/or discharge in addition to the batteries 151. For example, a power divider may be provided. As an example, the battery system 15 of the present embodiment includes the batteries 151, an auxiliary battery 152 for charging the batteries 151, and charge-related equipment 153 (see FIG. 4). The charge-related equipment 153 controls charge, for example, from the auxiliary battery 152 to the batteries 151. Details of the battery system 15 will be described later.

The EPU 16 includes a motor and an inverter, and rotationally drives the rotor blade 13 that applies a propulsive force to the eVTOL 10. The EPU 16 is equipment for rotationally driving the rotor blade 13. As an example, the same number of EPUs 16 as the number of the rotor blades 13 are provided. That is, the eVTOL 10 includes six EPUs 16. The EPU 16 and the rotor blade 13 are connected on a one-to-one basis. Alternatively, two or more rotor blades 13 may be configured to be connected to one EPU 16 via a gearbox.

The BMS 17 monitors the state of the battery 151. BMS is an abbreviation for battery management system. The BMS 17 can monitor the voltage, current, temperature, internal resistance, SOC, SOH, and other safety-related states such as the internal pressure and gas leakage of the battery 151. SOH is an abbreviation for state of health. For example, one BMS 17 is provided for one battery 151. The BMS 17 monitors the state of each of the batteries 151.

The eVTOL 10 further includes the ECU 20 and an auxiliary machine not illustrated. The ECU is an abbreviation for electronic control unit.

<Operation Management System>

The operation management system is a system for making an operation plan, monitoring an operation status, collecting and managing information regarding an operation, supporting an operation, and the like. At least some of the functions of the operation management system may be arranged in an onboard computer of the eVTOL 10. At least some of the functions of the operation management system may be arranged in an external computer that can wirelessly communicate with the eVTOL 10. An example of the external computer is a server 31 of a ground station 30 illustrated in FIG. 2. The ground station 30 can wirelessly communicate with the eVTOL 10. The ground stations 30 can wirelessly communicate with each other.

As an example, in the present embodiment, some of the functions of the operation management system are arranged in the ECU 20 of the eVTOL 10, and some of the functions of the operation management system are arranged in the server 31 of the ground station 30. The functions of the operation management system are shared between the ECU 20 and the server 31.

As illustrated in FIG. 2, the ECU 20 is configured to include a processor (PC) 201, a memory (MM) 202, a storage (ST) 203, and a communication circuit (CC) 204 for wireless communication. The processor 201 executes various processing by accessing the memory 202. The memory 202 is a rewritable volatile storage medium. The memory 202 is, for example, a RAM. RAM is an abbreviation for random access memory. The storage 203 is a rewritable nonvolatile storage medium. The storage 203 stores a program (PG) 203P executed by the processor 201. By causing the processor 201 to execute commands, the program 203P constructs functional units. The ECU 20 may include plural processors 201.

Similarly to the ECU 20, the server 31 is configured to include a processor (PC) 311, a memory (MM) 312, a storage (ST) 313, and a communication circuit (CC) 314. A processor 311 executes various processing by accessing a memory 312. The memory 312 is a rewritable volatile storage medium, and is, for example, a RAM. The storage 313 is a rewritable nonvolatile storage medium. The storage 313 stores a program (PG) 313P executed by the processor 311. By causing the processor 311 to execute commands, the program 313P constructs functional units. The server 31 may include plural processors 311.

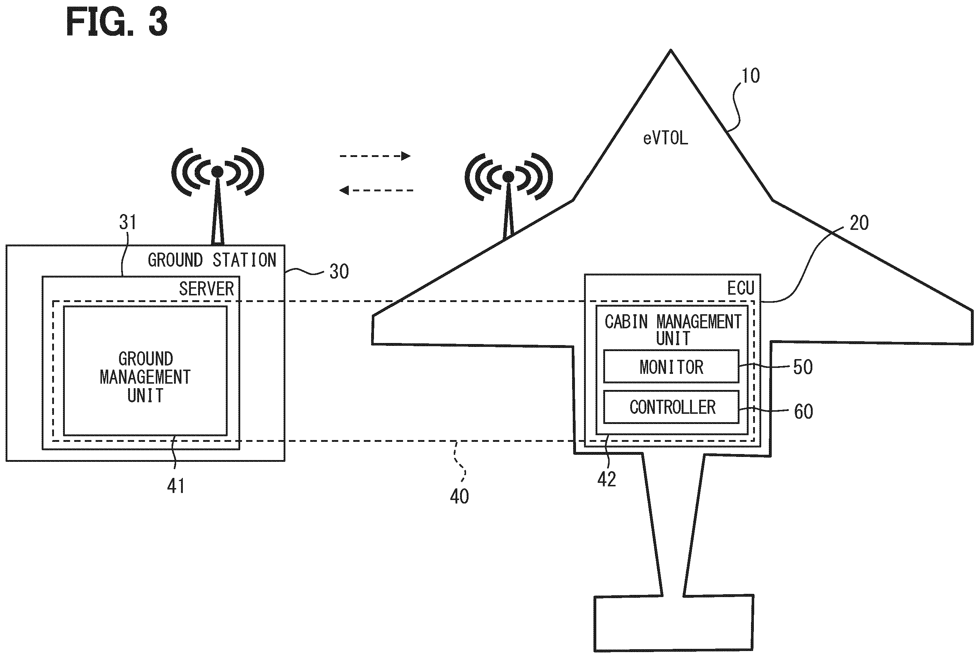

FIG. 3 illustrates an example of a functional arrangement of the operation management system. As illustrated in FIG. 3, as an example, an operation management system 40 of the present embodiment includes a ground management unit 41 and a cabin management unit 42. The ground management unit 41 is functionally arranged in the server 31 of the ground station 30. The cabin management unit 42 is functionally arranged in the ECU 20 of the eVTOL 10. In this manner, some of the functions of the operation management system 40 are arranged in the server 31, and the some other functions are arranged in the ECU 20. The ground management unit 41 and the cabin management unit 42 can wirelessly communicate with each other. The cabin management unit 42 can communicate with various devices arranged in the eVTOL 10 in a wired or wireless manner.

FIG. 4 illustrates a schematic configuration of an operation management system. As described above, the operation management system 40 makes an operation plan, monitors an operation status, collects and managing information regarding an operation, supports an operation, and the like. The operation management system 40 includes a monitor 50 and a controller 60 as functional units.

The monitor 50 acquires information regarding the battery 151 and monitors the state of the battery 151. The monitor 50 calculates and monitors the degree of temporary deterioration based on the acquired information. The monitor 50 may determine whether a predetermined condition is satisfied based on the degree of temporary deterioration.

The monitor 50 may be functionally arranged in the ECU 20 of the eVTOL 10 or may be functionally arranged in the server 31 of the ground station 30. The monitor 50 may be arranged as a part of the ground management unit 41, or may be arranged as a part of the cabin management unit 42. The monitor 50 may be arranged separately from the BMS 17, or at least a part of the monitor 50 may be arranged in the BMS 17. As an example, the monitor 50 of the present embodiment is functionally arranged in the ECU 20 of the eVTOL 10. The monitor 50 is arranged as a part of the cabin management unit 42.

The controller 60 controls discharge and/or charge of the battery 151 based on the degree of temporary deterioration. As an example, the controller 60 of the present embodiment acquires the degree of temporary deterioration from the monitor 50, and controls discharge and/or charge of the battery 151 based on the degree of temporary deterioration. The controller 60 may execute only discharge control or only charge control. The discharge control and the charge control may be executed. Hereinafter, controlling discharge and/or charge of the battery 151 may be called charge-discharge control. Details of the controller 60 will be described later.

The controller 60 may be functionally arranged in the ECU 20 of the eVTOL 10 or may be functionally arranged in the server 31 of the ground station 30. The controller 60 may be arranged as a part of the ground management unit 41, or may be arranged as a part of the cabin management unit 42. As an example, the controller 60 of the present embodiment is functionally arranged in the ECU 20 of the eVTOL 10. The controller 60 is arranged as a part of the cabin management unit 42. The controller 60 includes an arithmetic processing device common to the monitor 50.

The operation management system 40 may further include a display device 70. The display device 70 is arranged inside the eVTOL 10 and/or at the ground station 30. The display device 70 displays a monitoring result and a determination result by the monitor 50, for example. This can notify parties inside the aircraft and the ground station 30 of the monitoring result and the like. The display device 70 may display calculation results and the like of the controller 60 and other functional units.

The operation management system 40 also includes an operation planning device not illustrated. The operation planning device makes an operation plan for the eVTOL 10 based on, for example, information input from a terminal not illustrated. The input information includes, for example, information regarding a departure point and an arrival point. The operation planning device may make an operation plan in consideration of battery information and weather information.

<Monitor>

As described above, by causing the processor 201 to execute commands, the program 203P constructs the monitor 50, which is a functional unit.

The monitor 50 monitors the state of the battery 151, specifically, the degree of temporary deterioration. The monitor 50 may monitor the state of the battery 151 in units of battery packs or in units of battery modules. The monitoring may be performed in units of battery cells. Monitoring in units of battery cells can further enhance accuracy.

As described above, high output characteristics of the battery 151 are required for takeoff and landing of the eVTOL 10. Therefore, the monitor 50 preferably monitors the degree of temporary deterioration that greatly affects the high output characteristics at least by a predetermined period before the start of takeoff or the start of landing. The predetermined period is set based on a period necessary for processing for reducing the degree of temporary deterioration. For example, a predetermined time may be set based on a result obtained by a preliminary experiment, or the predetermined time may be set based on a past flight record. In order to increase the safety factor, a predetermined margin may be added.

As illustrated in FIG. 4, the monitor 50 includes an acquisition unit 51, a calculation unit 52, a determination unit 53, and an output unit 54.

The acquisition unit 51 acquires information regarding the battery 151. The acquisition unit 51 acquires information on each of the batteries 151. The acquisition unit 51 acquires information regarding the battery from the BMS 17. As described above, the BMS 17 monitors the voltage, current, temperature, internal resistance, SOC, SOH, and other safety-related states such as the internal pressure and gas leakage. The acquisition unit 51 acquires at least part of the information.

The acquisition unit 51 may acquire at least one of flight information, weather information, and rule information in addition to the battery information. The flight information can include, for example, the flight altitude, flight velocity, attitude (angle), and flight position in the current flight. As the flight information, information such as a flight altitude and flight velocity based on the operation plan may be acquired in addition to information on the current flight. The weather information can include, for example, wind direction, wind speed, and atmospheric pressure. The information such as regulations and rules can include, for example, the presence or absence of silent regulations, and rules of flight altitude.

The calculation unit 52 calculates the degree of temporary deterioration of the battery 151 based on the acquired battery information. The degree of temporary deterioration is a difference (ΔR) of the internal resistance from a reference value. The reference value is an initial internal resistance value before takeoff in the current flight, for example. The reference value may be a value of the internal resistance after the temporary deterioration elimination processing. For example, it may be a value of the internal resistance after charge on the ground. The reference value is preferably a value of the internal resistance after the temporary deterioration is sufficiently eliminated. The calculation of the degree of temporary deterioration may be an actual measurement calculation based on an actual measured value or a prediction calculation based on a predicted value. The calculation value may be the degree of temporary deterioration at the time point of monitoring, or may be the degree of temporary deterioration at the time point of takeoff or at the time point of landing.

The calculation unit 52 may calculate the degree of temporary deterioration using raw data of the battery 151 acquired from the BMS 17, for example, voltage, current, temperature, and the like. The calculation unit 52 may acquire data calculated by the BMS 17 and obtain the degree of temporary deterioration by additional calculation. The degree of temporary deterioration can be calculated based on, for example, one of the current history, internal resistance, and history information of past flights.

One of the techniques based on the current history is integration of current. The integrated value of the current can be used as the degree of temporary deterioration. In the case of the eVTOL 10, basically only output (discharge) is performed during flight (navigation). Therefore, the integrated value of the discharge current may be used as the degree of temporary deterioration during the flight.

However, charge on the ground or charge during the flight acts in a direction of eliminating the concentration imbalance caused by discharge to a considerable extent. Therefore, when charge is performed, the integrated value of the charge-discharge current may be used as the degree of temporary deterioration. By comparing the integrated value of the charge current with the integrated value of the discharge current, it is also possible to determine whether the concentration imbalance is caused by discharge or caused by charge.

An output stop at the time of standby on the ground or a temporary output stop during flight also acts in a direction of eliminating the concentration imbalance caused by discharge to a considerable extent. Therefore, the current integrated value may be corrected in a direction of eliminating the concentration imbalance. The correction value may be calculated using a map or a regression model created in advance from data such as an experiment.

The larger the current is (the higher the output is) or the longer the duration of the output is, the more likely the concentration imbalance is to occur. Therefore, in a case where the integrated value of the current is used, the value may be integrated while weighting for each current value and/or duration. The weighting coefficient may be calculated using a map or a regression model created in advance from data such as an experiment.

Another one of techniques based on the current history is calculation using a battery physical model. The battery physical model is a model that can model an electrochemical reaction and material transport and analyze the concentration distribution. When the current history is input to this battery physical model to perform calculation, it is possible to estimate a concentration imbalance of ions in an electrolytic solution or an electrode that contributes to the battery reaction. Therefore, the degree of temporary deterioration can be obtained with high accuracy.

One of the techniques based on the internal resistance is calculation of an increase amount (change amount) of the internal resistance. That is, the degree of temporary deterioration itself is calculated. The change amount is a decrease amount at the time of elimination of the temporary deterioration. The resistance increase amount of the battery 151 can be calculated using a time-series value of the internal resistance calculated from the voltage, the current, and the like of the battery 151. The monitor 50 may acquire the internal resistance from the BMS 17, or the calculation unit 52 may calculate the internal resistance.

Another one of techniques using the internal resistance is calculation using estimated resistance by a battery model. The battery model is, for example, a battery equivalent circuit model. The estimated resistance is obtained from an estimated current estimated from the battery model in which the concentration distribution is assumed to be uniform and an actually measured voltage. The degree of temporary deterioration can be calculated from the difference between the estimated resistance and the measured resistance obtained from the actually measured current and the actually measured voltage.

Another one of techniques using the internal resistance is calculation based on the resistance component of the alternating-current impedance. The increase amount (change amount) of the resistance component of the alternating-current impedance of the battery 151 can be used as the degree of temporary deterioration. The change amount is a decrease amount at the time of elimination of the temporary deterioration. In particular, the increase amount of the resistance component in a high frequency region of the alternating-current impedance may be used as the degree of temporary deterioration. The degree of concentration imbalance in the electrolytic solution, which is a main factor of the imbalance, can be calculated more accurately.

Use of the alternating-current impedance enables factor separation of resistance. In the reaction of the battery, when a voltage is applied, first, an electric double layer is formed, and then a charge-transfer reaction (electron transfer reaction) occurs. In a high frequency region of about 1 kHz, ohmic resistance of a lead or the like and movement resistance of an electrolyte solution are shown. Since the main factor of temporary deterioration is an imbalance in ion concentration in the electrolytic solution, the calculation can be made more accurate by using the resistance in which the factor is separated in the high frequency region. For measurement of the resistance component of the alternating-current impedance, for example, the BMS 17 having a function of measuring the alternating-current impedance by superimposing the alternating-current current and an analysis function can be used.

The technique based on the history information of past flights is prediction calculation of the degree of temporary deterioration utilizing the history information. At takeoff and landing times, high output is required continuously for a predetermined time. For this reason, the ratio of the capacity required at the takeoff time and/or landing time to the total capacity of the battery is high. At takeoff and landing times, in addition to having a large influence on the battery due to a high output or a high capacity, it is susceptible to the influence of the environment of the takeoff point or the landing point, for example, the wind direction, the wind speed, the atmospheric pressure, the weather, and the like. Therefore, an error is likely to occur in the prediction of the state of the battery at the operation time. Therefore, in the present technique, the degree of temporary deterioration is predicted based on the history information.

As the history information, information regarding the degree of past temporary deterioration that matches the flight for which the takeoff point and/or the landing point and the model are targets is used. Since the operation plan of the eVTOL 10 is finite and has a high repetition frequency, history information can be utilized. Furthermore, since the history information at the takeoff point and the landing point where the prediction error is likely to occur is utilized, the prediction accuracy of the degree of temporary deterioration can be enhanced. Ease of operation, output characteristics, and the like vary depending on the model of the eVTOL 10. This can further enhance the prediction accuracy of the degree of temporary deterioration.

The degree of temporary deterioration may be predicted based on a prediction map. Alternatively, the degree of temporary deterioration may be predicted based on a prediction model such as multiple regression. As an example, the degree of temporary deterioration is predicted based on a prediction model generated using machine learning. Use of the prediction model enables high accuracy of prediction and high speed of prediction even in a case where there are many explanatory variables. The prediction model can be easily constructed by generating the prediction model by machine learning. Furthermore, the prediction accuracy can be further improved by increasing the history information.

The explanatory variable may be called an input variable, an input item, or the like. An explanatory variable is input to a prediction model, thereby obtaining an objective variable. The degree of temporary deterioration of the battery is obtained as the objective variable. The objective variable may be called an output variable, an output item, or the like. By constructing the prediction model and the prediction map with important factor parameters as explanatory variables, the prediction accuracy of the degree of temporary deterioration can be enhanced.

One of the important factor parameters is history information of the takeoff point and landing point same as those of the target flight, and another one of the important factor parameters is history information of the same model. These pieces of information may be called basic information. However, as other factor parameters (basic information), history information of the flight altitude, history information of the flight route, history information of the time zone of takeoff or landing, and the like may be added. The flight altitude affects, for example, air density, atmospheric pressure, outside temperature, output required for altitude, and the like. The flight route affects, for example, the flight distance, the outside temperature, and the like. The time zone affects, for example, the outside temperature, the standby time, and the like. The prediction accuracy can be further enhanced by adding other factor parameters that are likely to cause errors.

As described above, high output is required continuously for a predetermined time at takeoff and landing times when moving with a vertical component. Therefore, as information other than the basic information described above, that is, as other information, factor parameters that greatly affect the maximum output and the power amount at takeoff and landing times may be added to the explanatory variables of the prediction model. This can enhance the prediction accuracy.

One of the factor parameters that are other information is weather information of the takeoff point and/or the landing point of a target flight. As an example, information used for prediction together with the basic information includes weather information of the target takeoff point and/or landing point. The weather conditions at the takeoff point and the landing point, for example, the wind direction, the wind speed, the atmospheric pressure, and the like affect the operation at takeoff and landing times of the eVTOL 10. By adding weather information of the takeoff point or the landing point to factor parameters, it is possible to further enhance prediction accuracy.

Another one of the factor parameters that are other information is operation characteristic information in the target flight. As an example, operation characteristic information in the target flight is included as information used for prediction together with the basic information. Individual variations in operation characteristics in the same model affect the operation at takeoff and landing times of the eVTOL 10 regardless of the manned aircraft and the unmanned aircraft. Variations in operation characteristics such as the skill (proficiency) and habit of the operator also affect the operation of the eVTOL 10 at takeoff and landing times. Variations in airframe factors and variation in operator factors appear in the moving speed in the up-down direction, the horizontal direction, and the inclination direction, the adjustment time of the airframe position with respect to the landing point, the transition time from the cruise mode to the landing mode, and the like. As the operation characteristic information, for example, the operation characteristic information such as the moving speed, the adjustment time, and the transition time described above is added to the factor parameters, whereby the prediction accuracy can be further enhanced.

Another one of the factor parameters that are other information is the mounting weight. The mounting weight is a weight of an occupant (person), a conveyance object, or the like. As the mounting weight is larger, higher output is required. By adding the mounting weight to the factor parameter, it is possible to further enhance the prediction accuracy.

The factor parameters that greatly affect the maximum output and the power amount at takeoff and landing times are not limited to the above examples. In the case of a prediction model generated by machine learning, if the machine learning proceeds together with accumulation of history information, a new factor parameter can be extracted as other information.

The determination unit 53 determines whether a predetermined condition is satisfied based on the degree of temporary deterioration calculated by the calculation unit 52. The determination unit 53 may determine necessity of a takeoff restriction or a landing restriction of the VTOL 10, for example. As described above, high output characteristics are required at landing or takeoff times. When the internal resistance of the battery 151 rises, the output performance of the battery 151 decreases even if the SOC of the battery 151 is sufficient. By determination based on the degree of temporary deterioration, it is possible to grasp whether performance required at takeoff or landing times can be exhibited. Therefore, appropriate flight restrictions can be achieved.

The determination unit 53 may determine necessity of maintenance of the battery 151 based on the degree of temporary deterioration. It is possible to grasp whether maintenance of the battery 151 is necessary by the determination based on the degree of temporary deterioration. For example, it is possible to grasp whether replacement of the battery 151 is necessary. Therefore, it is possible to achieve appropriate maintenance for ensuring the safety of navigation.

The threshold (determination criterion) used for the necessity determination may be set based on the history information of the past flights. For example, it may be set based on history information of the target flight and past flights in which the departure point and/or the arrival point and the model match. The history information is information regarding the degree of temporary deterioration and takeoff and landing restrictions, or information regarding the degree of temporary deterioration and maintenance. As described above, since the operation plan of the eVTOL 10 is finite and has a high repetition frequency, the history information can be utilized. In particular, since the history information in which the takeoff and landing points that are likely to cause an error and the model match is used, an appropriate threshold can be set.

The output unit 54 outputs the calculation result of the calculation unit 52 to the outside of the monitor 50. The output unit 54 outputs the degree of temporary deterioration to the controller 60. The output unit 54 outputs the determination result of the determination unit 53 to the outside of the monitor 50. The output unit 54 outputs the determination result of the determination unit 53 to, for example, the controller 60. The output unit 54 outputs the determination result of the determination unit 53 to, for example, the display device 70. The output unit 54 may output the calculation result of the calculation unit 52 to the display device 70. The output unit 54 may output the information acquired by the acquisition unit 51 to the controller 60 or the display device 70.

The permanent deterioration of the battery is negligible in one flight, and thus may be ignored. The permanent deterioration may be called aged deterioration, persistent deterioration, or the like. However, there are possibilities that the permanent deterioration rapidly increases at the end of the life of the battery that should be replaced and that the permanent deterioration rapidly increases due to a battery abnormality (disconnection or the like). The relationship between the SOH and the charge-discharge conditions and the increase in permanent deterioration may be obtained by an experiment or the like, mapped or modeled, and the increase in permanent deterioration in the present flight may be estimated. An increase due to permanent deterioration may be estimated based on the history of the past flight. The degree of temporary deterioration can be calculated with high accuracy by subtracting the increase due to permanent deterioration. At the time of abnormality detection based on battery variation information, monitoring by the monitor 50 may be restricted, for example, stopped, in order to restrict erroneous diagnosis.

<Operation Management Method>

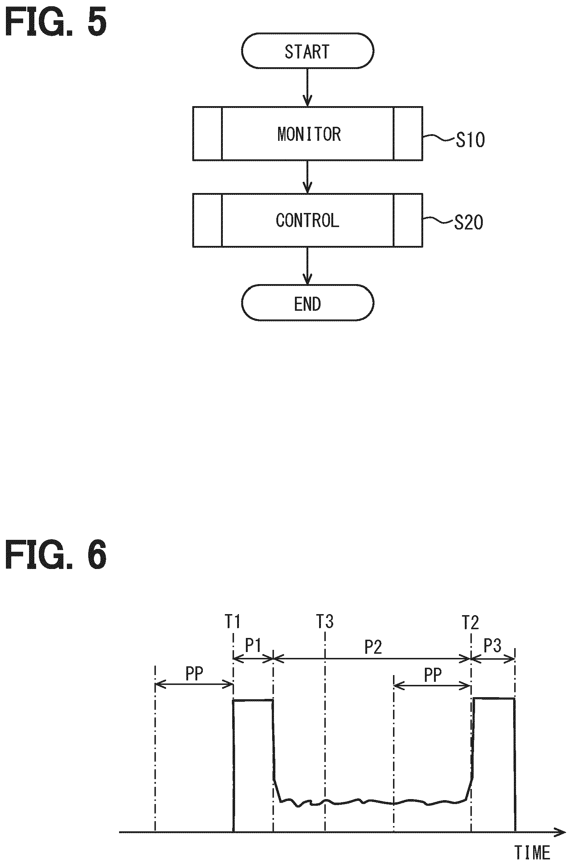

FIG. 5 is a flowchart showing one of operation management methods for the operation management system 40 to manage the operation of the eVTOL 10. Execution of processing of each functional block of the operation management system 40 by the processor 201 corresponds to execution of the operation management method.

The operation management system 40 executes processing shown in FIG. 5. The operation management system 40 executes the processing shown in FIG. 5 at least once for one flight. The operation management system 40 executes the processing shown in FIG. 5 based on a predetermined trigger.

First, the monitor 50 executes processing of monitoring the battery state (step S10). As an example, in the present embodiment, the degree of temporary deterioration is monitored by acquiring information regarding the battery and calculating the degree of temporary deterioration. Details of the monitoring processing will be described later.

Next, the controller 60 executes control based on the information acquired in step S10 (step S20). The controller 60 controls charge and/or discharge of the battery 151 based on, for example, the degree of temporary deterioration. After the execution of step S20, the series of processing ends.

<Monitoring Method>

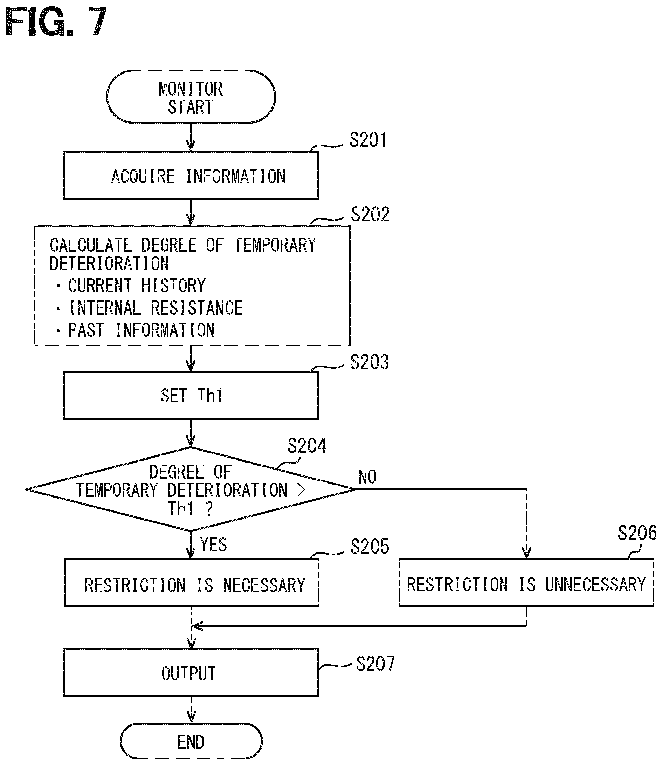

FIG. 6 is a view illustrating the execution timing of the monitoring processing. FIG. 7 shows the processing of step S10 described above, that is, the monitoring method. Execution of processing of each functional block of the monitor 50 by the processor 201 corresponds to execution of the monitoring method.

The monitor 50 executes the monitoring processing based on the predetermined trigger. T1 illustrated in FIG. 6 is a start timing of the takeoff period P1. T2 is a start timing of the landing period P3. T1 and T2 are start timings in the operation plan. As described above, the monitor 50 monitors the degree of temporary deterioration that greatly affects the high output characteristics at least by a predetermined period before the start of takeoff or the start of landing. A predetermined period PP is set based on a period necessary for processing for the controller 60 to reduce the degree of temporary deterioration. The predetermined period can be set based on preliminary experiments or past flight records as described above. As an example, in the present embodiment, a timing T3, which is a period backward from the start timing T2 by the predetermined period PP added with a margin, is set as the trigger generation timing. When the trigger is generated, the monitor 50 (operation management system 40) starts processing.

The trigger generation timing may be a timing backward from the start timing T1 by the predetermined period PP added with a margin. Although an example in which the margin is added has been described, it is not limited to this.

As shown in FIG. 7, first, the monitor 50 acquires various types of information including information regarding the battery 151 (step S201). The acquisition unit 51 acquires information regarding the voltage, current, temperature, resistance, and the like of the battery 151 from the BMS 17, for example. The acquisition unit 51 may acquire at least one of flight information, weather information, and regulation information together with the battery information.

Next, the monitor 50 calculates the degree of temporary deterioration based on the acquired battery information (step S202). As described above, the monitor 50 calculates the degree of temporary deterioration based on any of the current history, internal resistance, and history information (past information) of the past flights. As an example, the monitor 50 of the present embodiment calculates the degree of temporary deterioration by integrating the current.

Next, the monitor 50 sets a threshold Th1 used for determination (step S203). As described above, the monitor 50 sets the threshold Th1 used for necessity determination based on the history information of the past flights. The history information is information regarding the degree of temporary deterioration and takeoff and landing restrictions, for example, in a target flight and past flights in which the departure point and/or the arrival point and the model match.

The setting of the threshold Th1 may be executed before step S204. For example, it may be executed before steps S201 and S202. The threshold Th1 may be set at a timing different from that of the present processing. If a preset predetermined value is used in place of the history information, the processing of step S203 can be omitted.

Next, the monitor 50 determines whether the degree of temporary deterioration is greater than the threshold Th1 (step S204). That is, the determination unit 53 determines necessity of a takeoff restriction or a landing restriction. If the degree of temporary deterioration is greater than the threshold Th1, the determination unit 53 determines that the takeoff restriction or the landing restriction is necessary. As an example, in the present embodiment, it is determined that the landing restriction is necessary (step S205). If the degree of temporary deterioration is equal to or less than the threshold Th1, the determination unit 53 determines that the takeoff restriction or the landing restriction is unnecessary. As an example, in the present embodiment, it is determined that the landing restriction is unnecessary (step S206).

Next, the monitor 50 outputs a monitoring result and the like to the outside of the monitor 50 (step S207). The output unit 54 outputs the degree of temporary deterioration. The output unit 54 outputs a determination result (necessity of landing restriction). The output unit 54 outputs part of the information acquired by the acquisition unit 51. The series of processing ends.

<Summary of First Embodiment>

As described above, the monitor 50 of the present embodiment acquires information regarding the battery 151, and calculates the degree of temporary deterioration caused by the imbalance in ion concentration based on the information. The degree of temporary deterioration can be grasped based on the battery information. The calculation result is output. In this manner, since the degree of temporary deterioration can be grasped, appropriate processing leading to flight safety, for example, flight control and maintenance can be performed. Therefore, the flight safety can be enhanced.

As an example, the calculation unit 52 of the present embodiment calculates the degree of temporary deterioration by a predetermined period before start of landing at a cruise time of the eVTOL 10 and/or by a predetermined period before start of takeoff of the eVTOL 10. This enables appropriate processing based on the degree of temporary deterioration before takeoff and landing requiring high output. Therefore, the flight safety can be further enhanced. In particular, by setting the predetermined period based on a period necessary for processing for reducing the degree of temporary deterioration, it is possible to restrict in advance/eliminate an abnormality before takeoff and landing.

The calculation unit 52 may calculate the degree of temporary deterioration based on a discharge history or a charge-discharge history of the battery 151 during flight. The discharge history may be called an output history, and the charge-discharge history may be called an input-output history. The discharge history and the charge-discharge history are current histories of the battery 151. This can accurately estimate the degree of temporary deterioration only with basic data normally output from the battery 151.

The calculation unit 52 may calculate the degree of temporary deterioration based on the resistance of the battery 151. For example, use of an actual measurement value of the internal resistance directly and easily enables estimation of the degree of temporary deterioration. The calculation unit 52 may calculate the degree of temporary deterioration based on the resistance component of the alternating-current impedance of the battery. This can accurately calculate the degree of concentration imbalance in the electrolytic solution, which is a main factor of the imbalance.

The calculation unit 52 may calculate the degree of temporary deterioration based on information on the battery state of the target flight and the past flights in which the model and the takeoff point and/or the landing point match. The history information of the same model and the same takeoff and landing points has high reproducibility. Therefore, it is possible to accurately calculate the degree of temporary deterioration while suppressing loads on measurement and calculation at the time of flight.

As an example, the monitor 50 of the present embodiment determines the necessity of the takeoff restriction or the landing restriction of the eVTOL 10 based on the degree of temporary deterioration, and outputs information regarding the necessity. According to this, it is possible to grasp whether the battery 151 can exhibit performance necessary for takeoff and landing based on the degree of temporary deterioration. For example, by outputting to the display device 70, parties inside and outside the aircraft can notify the necessity of takeoff and landing restrictions. By outputting to the controller 60, it is possible to execute control in consideration of necessity of takeoff and landing restrictions. That is, it is possible to achieve appropriate flight restriction.

As an example, in the present embodiment, the threshold used for necessity determination is set based on the target flight and the history information of the past flights in which the takeoff point and/or the landing point and the model match. The history information of the same model and the same takeoff and landing points has high reproducibility. Therefore, the determination can be made with an appropriate threshold.

The program (program 203P) of the present embodiment includes causing at least one processor 201 (processing unit) to acquire information regarding the battery and to calculate the degree of temporary deterioration caused by an imbalance in ion concentration of the battery based on the information. According to this program, it is possible to calculate the degree of temporary deterioration based on the battery information. This enables appropriate processing of grasping the degree of temporary deterioration and leading to flight safety, for example, flight control and maintenance. Therefore, the flight safety can be enhanced.

<Modification>

While an example in which the monitor 50 includes the determination unit 53 has been described, it is not limited to this. The determination unit 53 may be eliminated.

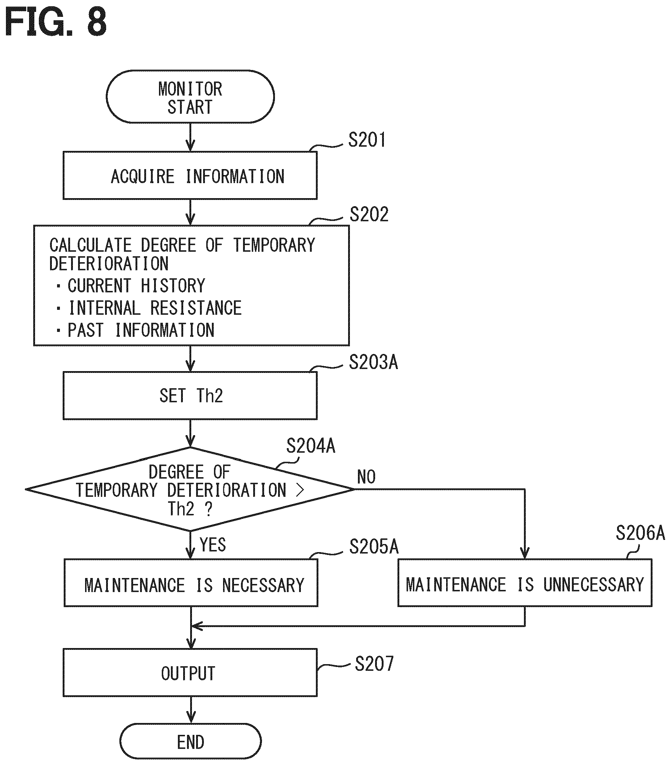

As illustrated in FIG. 8, the determination unit 53 of the monitor 50 may determine necessity of maintenance of the batteries 151 based on the degree of temporary deterioration. In FIG. 8, steps S203, S204, S205, and S206 shown in FIG. 7 are replaced with steps S203A, S204A, S205A, and S206 A. In step S203A, the monitor 50 sets a threshold Th2 for necessity determination. The threshold Th2 can be set by the same technique as that of the threshold Th1. In step S204A, the monitor 50 determines whether the degree of temporary deterioration is greater than the threshold Th2. If the degree of temporary deterioration is greater than the threshold Th2, the monitor 50 determines in step S205A that maintenance is necessary. If the degree of temporary deterioration is equal to or less than the threshold Th2, the monitor 50 determines in step S206A that maintenance is unnecessary. By outputting the determination result of the necessity of maintenance to the display device 70, for example, parties inside and outside the aircraft can notify the necessity of maintenance. Therefore, it is possible to achieve appropriate maintenance for ensuring the safety.

While a combination of the monitor 50 and the controller 60 has been described, it is not limited to this. The monitor 50 may be configured be included alone. For example, the output destination of the monitor 50 is not limited to the controller 60.

(Second Embodiment)

This embodiment is a modification based on the preceding embodiment, and the description of the preceding embodiment can be incorporated. In the preceding embodiment, the configuration that can monitor the degree of temporary deterioration has been described in detail. In the present embodiment, a configuration that can reduce the degree of temporary deterioration will be described.

<Control Device>

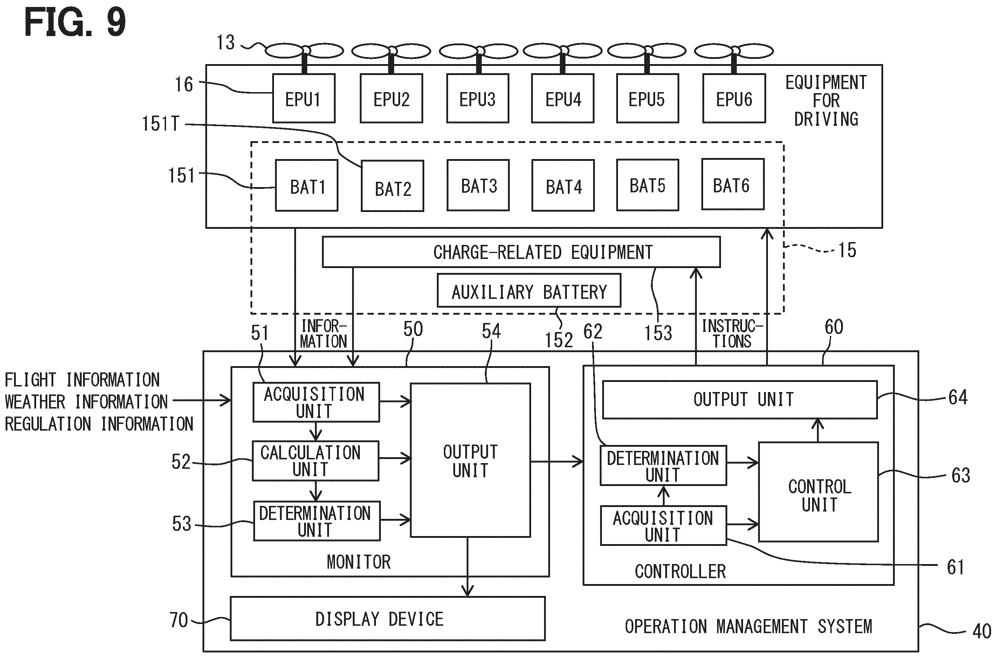

FIG. 9 is a view illustrating a schematic configuration of the operation management system 40 according to the present embodiment. FIG. 9 corresponds to FIG. 4. As illustrated in FIG. 9, the controller 60 includes an acquisition unit 61, a determination unit 62, a control unit 63, and an output unit 64.

The acquisition unit 61 acquires information regarding the degree of temporary deterioration of the battery 151. As an example, the acquisition unit 61 of the present embodiment acquires the degree of temporary deterioration from the monitor 50. However, the degree of temporary deterioration is not limited to that obtained by monitoring by the monitor 50. The degree of temporary deterioration may be, for example, an estimated value based on the operation plan and the history information of past flights. The estimation may be executed by a functional unit not illustrated of the controller 60. In the operation management system 40, a functional unit other than the monitor 50 and the controller 60 may execute the estimation.

For example, when it is assumed that the degree of temporary deterioration becomes great than a threshold that is a predetermined reference based on history information at a specific timing during operation, the degree of temporary deterioration may be used as an estimated value. The history information is preferably history information of a past flight in which the model and the takeoff point and/or the landing point match with respect to the present flight.

The acquisition unit 61 may acquire information regarding other batteries 151, such as a battery temperature. The acquisition unit 61 may acquire information other than the information regarding the battery 151, for example, at least one of flight information, weather information, and regulation information. As an example, the acquisition unit 61 of the present embodiment acquires these pieces of information from the monitor 50. The acquisition unit 61 may acquire the above-described information not via the monitor 50.

The determination unit 62 executes predetermined determination based on the information acquired by the acquisition unit 61. For example, the determination unit 62 compares the degree of temporary deterioration with a threshold that is a predetermined reference, and outputs the determination result to the control unit 63. The determination unit 62 determines whether execution of recovery control described later is necessary. The threshold for determining whether to execute recovery control is set so as not to make battery output characteristics required at landing or takeoff times insufficient. When there is a possibility of insufficiency due to the degree of temporary deterioration exceeding the threshold value, the control unit 63 executes recovery control. The threshold may be set with a predetermined margin being added, or the threshold may be changed based on the operation plan of the present flight.

For example, the determination unit 62 compares the battery temperature with a predetermined temperature, and outputs the determination result to the control unit 63. When the temperature of the battery 151 is high, ions contributing to the battery reaction are easily diffused, and concentration imbalance is easily eliminated. Since it is more efficient to perform the recovery control in a state where the battery temperature is high, the determination unit 62 determines whether the recovery control can be efficiently executed. The threshold (predetermined temperature) used for the determination may be set by, for example, data obtained in a preliminary experiment.

As described above, the control unit 63 controls discharge and/or charge of the battery 151 based on the degree of temporary deterioration. As an example, the control unit 63 of the present embodiment controls discharge and/or charge of the battery 151 based on the degree of temporary deterioration acquired from the monitor 50.

The control unit 63 may indirectly control charge and discharge of the battery 151 by controlling a drive target driven by electric power of the battery 151. The drive target includes the rotor blade 13, that is, the EPU 16. The control unit 63 may control charge and discharge of the battery 151 by executing flight control including processing of controlling drive of the rotor blade 13. The flight control may include processing of adjusting the tilt mechanism 141 and the flap 142.

The drive target may include an auxiliary machine such as an air conditioner. The control unit 63 may control charge and discharge of the battery 151 by controlling drive of the auxiliary machine. The control unit 63 may directly control charge and discharge of the battery 151 by controlling the charge-related equipment 153. For example, the operation of the charge-related equipment 153 may be controlled such that the battery 151 is charged from the auxiliary battery 152. In this manner, the control unit 63 directly or indirectly controls charge and discharge of the battery 151.

If the degree of temporary deterioration of at least one battery 151 is greater than a threshold, the control unit 63 executes recovery control for performing control so as to reduce the degree of temporary deterioration of a target battery 151T. The reduction in the degree of temporary deterioration also includes delaying an increase in the degree of temporary deterioration. The control unit 63 does not execute the recovery control if the degree of temporary deterioration for all the batteries 151 is equal to or less than the threshold. That is, the control unit 63 executes normal control. The control unit 63 executes recovery control or normal control based on the determination result of the determination unit 62. The target battery 151T is a battery having a degree of temporary deterioration greater than a threshold among the batteries 151. In FIG. 9, as an example, the battery (BAT2) 151 is the target battery 151T.

The recovery control may be performed continuously or intermittently. The control time may be set based on the time of the recovery processing obtained in advance by an experiment or the like and the effect thereof. The control time may be set based on past history information. An elimination effect by the control, that is, the degree of temporary deterioration may be confirmed in real time, and the necessity of continuation of the processing may be determined.

The control unit 63 may temporarily reduce or stop the output of the target battery 151T as the recovery control. The progress of the concentration imbalance depends on the output of the battery 151, that is, the discharge current. Therefore, the progress of concentration imbalance can be suppressed by temporarily reducing the output of the target battery 151T. By temporarily stopping the output of the target battery 151T, diffusion of ions proceeds in the electrolytic solution, for example, and the concentration imbalance decreases. Therefore, the degree of temporary deterioration can be reduced.

The control unit 63 may temporarily charge or discharge the target battery 151T as the recovery control. The temporary charge or charge-discharge is charge performed for a short time with a limited capacity or the like, unlike normal power feeding.

When a concentration imbalance occurs due to discharge (output), the orientation of the current is changed by charging (inputting), and the concentration imbalance can be forcibly reduced. That is, the degree of temporary deterioration can be reduced. For example, the charge can be performed by a generator, a fuel cell, power regeneration, wireless power feeding, charge from a battery, a ground charger, or the like. As an example, in the present embodiment, charge is possible from the auxiliary battery 152 of the battery system 15. Other batteries 151 except the target battery 151T can be charged.

The concentration imbalance can be forcibly eliminated by applying an alternating current or temporarily charging and discharging a minute ΔSOC. A pulsating current such as a ripple may be applied, or charge and discharge may be repeatedly performed by a rectangular wave or the like. The discharge may be a battery output to the EPU 16, an auxiliary machine, or the like. The temporary charge and discharge is particularly effective when it is not possible to determine whether the concentration imbalance is due to discharge or charge, such as after rapid charge on the ground.

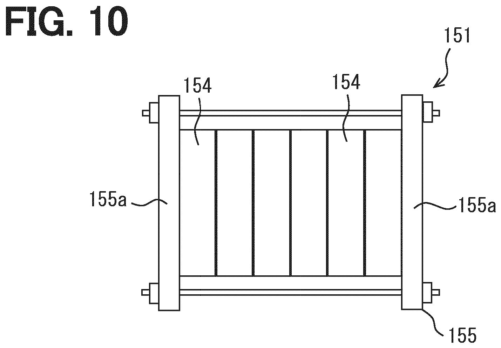

FIG. 10 illustrates an example of the battery 151 (battery module). Plural battery cells 154 included in the battery 151 are restrained by a fixing member 155. In FIG. 10, the battery cells 154 are stacked via an insulating member not illustrated. The fixing member 155 includes a pair of plates 155a. The fixing member 155 restrains the battery cells 154 by a structure in which the battery cells 154 are held between the pair of plates 155a in a stacking direction.

When the battery cell 154 is restrained at a constant size, the restraint load increases with deterioration of the battery cells 154, and the electrolytic solution is discharged to the outside of the electrode. In this manner, the concentration may be imbalanced by the decrease in the electrolytic solution amount in the electrode due to the restraint of the battery cells 154.

Therefore, in addition to/in place of the charge-discharge control, the control unit 63 may control the restraint state of the battery cell 154 by the fixing member 155. That is, the state of the battery 151 may be controlled. The control unit 63 may temporarily relax the restraint state of the battery cells 154 as the recovery control. For example, in the configuration illustrated in FIG. 10, the control unit 63 changes the relative positions of the pair of plates 155a in a direction in which the opposing surfaces are separated. By relaxing the restraint pressure of the battery cells 154, the impregnation amount in the electrode is recovered by the capillary phenomenon, and the concentration imbalance can be recovered.

The control unit 63 may execute plural recovery controls described above in combination. A higher reduction effect (recovery effect) can be obtained by the plural combinations.

The control unit 63 may execute the recovery control in a period excluding the takeoff time and landing time. By executing the recovery control in a period before takeoff or at a cruise time (period P2), it is possible to restrict in advance a battery output abnormality at landing or takeoff times. The control unit 63 may have a function of restricting takeoff or landing at the time of executing the recovery control. During execution of the recovery control, since the performance necessary for takeoff and landing cannot be secured, the safety can be secured by flight restriction.

The control unit 63 executes the recovery control when the temperature of the target battery 151T determined by the determination unit 62 is higher than a predetermined temperature. When the temperature of the target battery 151T is equal to or lower than the predetermined temperature, the control unit 63 increases the output of the target battery 151T, and executes the recovery control after the temperature becomes higher than the predetermined temperature. As described above, when the battery temperature is high, ions are easily diffused. By executing the recovery control when the temperature of the target battery 151T is higher than the predetermined temperature, it is possible to efficiently reduce the degree of temporary deterioration. When the temperature of the target battery 151T is equal to or lower than the predetermined temperature, by increasing the output of the target battery 151T, it is possible to raise the temperature by self-heating. This can shorten the control time.

The output increase of the target battery 151T can be achieved by controlling drive of the drive target. Preferably, the output of the target battery 151T may be increased by controlling the drive of the rotor blade 13 requiring a large electric power for flight. That is, the inverter of the EPU 16 supplied with power by the target battery 151T may be controlled to increase the rotation speed of the rotor blade 13. The temperature of the target battery 151T can be efficiently raised, and a dedicated device for heating the battery becomes unnecessary.

As described above, the control unit 63 controls the drive of the rotor blade 13, that is, the EPU 16. The control unit 63 may control the flight so as to achieve safe flight while recovering the target battery 151T by executing the recovery control. When executing the recovery control for stopping the output of the target battery 151T, the control unit 63 may secure thrust and lift necessary for the flight by drive of the rotor blade 13 by the output of other batteries 151 except for the target battery 151T whose output is stopped and lift adjustment of the lift adjustment mechanism 14.

Here, lift L acting on the eVTOL is expressed by Expression 1. Drag D is expressed by Expression 2. In Expressions 1 and 2, $\rho$ is the air density, V is the wing velocity, and S is the surface area of the fixed wing. The wing velocity V may be called airspeed, flight velocity, or the like. CL is a lift coefficient, and CD is a drag coefficient.

$$L = (CL \cdot \rho \cdot V^2 \cdot S)/2 \cdots \text{(Expression 1)}$$

$$D = (CD \cdot \rho \cdot V^2 \cdot S)/2 \cdots \text{(Expression 2)}$$

The lift L and the drag D increase as the wing velocity V (flight velocity) increases and decrease as the wing velocity decreases. The lift L and the drag D decrease because the air density $\rho$ decreases as the flight altitude increases, and increase because the air density $\rho$ increases as the flight altitude decreases. The lift L and the drag D can be varied by the lift coefficient CL and the drag coefficient CD determined by the surface area of the fixed wing and the airfoil.

Therefore, for stable and safe flight, it is preferable to adjust the lift, specifically the rotary lift and the gliding lift, so as to fall within the range of the flight velocity and flight altitude allowed based on rules and regulations in the flight region.

The control unit 63 may decrease the drag D of the airframe in order to secure necessary thrust. For example, by storing the rotor blade 13 being stopped into the airframe or in the fixed wing 12, it is possible to decrease the drag D, and reduce necessary thrust.

When the necessary thrust can be secured, the control unit 63 may simultaneously stop the target batteries 151T. The control unit 63 may sequentially stop the target batteries 151T in order to secure the necessary thrust. The control unit 63 may temporarily stop the output of all the batteries 151 under the condition that the thrust required for flight is zero, that is, what is called glider flight is permitted.

The control unit 63 adjusts the gliding lift by the fixed wing 12 by controlling the drive of the lift adjustment mechanism 14. As an example, the control unit 63 of the present embodiment executes processing of generating a control signal indicating a target tilt angle of each rotor blade 13 for achieving an instructed flight state. The control unit 63 outputs a control signal indicating the target tilt angle to a drive circuit not illustrated that drives the inverter of the tilt adjustment device. The drive circuit drives the motor of the tilt adjustment device via the inverter such that the tilt angle of the rotor blade 13 matches the target tilt angle.

The control unit 63 executes processing of generating a control signal indicating a target position of each flap 142 for achieving the instructed flight state. The control unit 63 outputs a control signal indicating the target position to a drive circuit not illustrated that drives the inverter of the flap adjustment device. The drive circuit drives the motor of the flap adjustment device via the inverter such that the position of the flap 142 matches the target position.

The control unit 63 adjusts the rotary lift by controlling the drive of the rotor blade 13. The control unit 63 executes processing of generating a control signal indicating the target rotation speed of each rotor blade 13 for achieving the instructed flight state. The control unit 63 outputs a control signal indicating the target rotation speed to a drive circuit (driver) not illustrated that drives the inverter of the EPU 16. The drive circuit drives the motor of the EPU 16 via the inverter such that the rotation speed of the rotor blade 13 matches the target rotation speed. The control unit 63 reduces the rotary lift by reducing the rotation speed of the rotor blade 13 or stops the rotation. When the control unit 63 increases the rotation speed of the rotor blade 13, the rotary lift increases. Since the thrust decreases when the rotation speed of the rotor blade 13 is decreased or the rotation is stopped, the control unit 63 perform adjustment in consideration of the thrust so as to fall within the range of the flight velocity and flight altitude allowed.

As described above, the control unit 63 can directly control charge and discharge of the battery 151 by controlling the charge-related equipment 153. Details of the configuration in which the control unit 63 temporarily charges or discharges the target battery 151T will be described later together with the configuration of the battery system 15 that is chargeable-dischargeable.

The output unit 64 outputs the control signal generated by the control unit 63 to a control target. In the operation management system 40, the configuration of the monitor 50 is similar to that of the preceding embodiment. For example, the controller 60 is functionally arranged in the ECU 20 similarly to the preceding embodiment.

<Control Method>

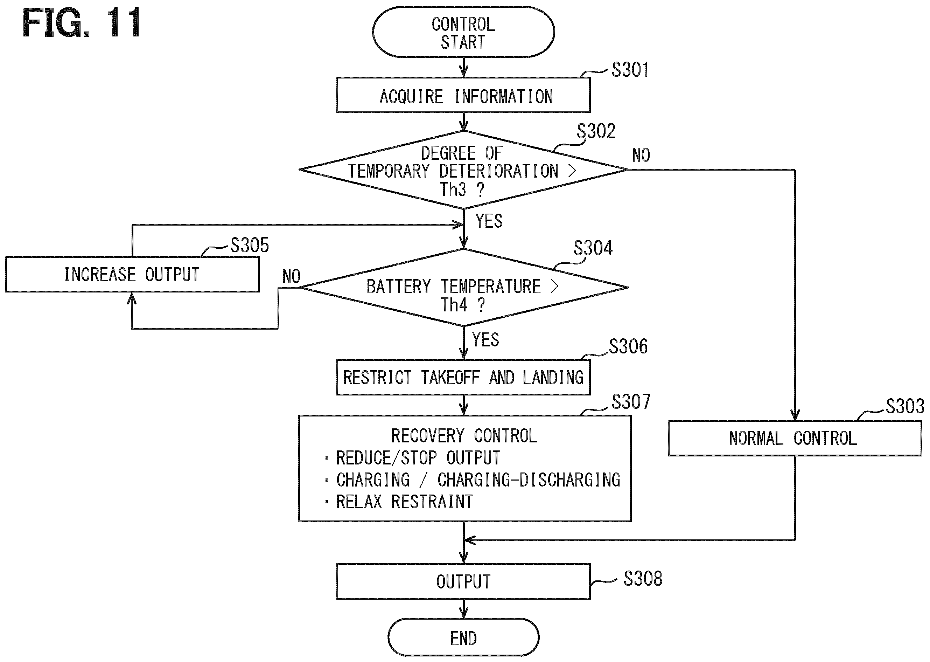

FIG. 11 shows the processing of step S20 described above, that is, the control method. Execution of processing of each functional block of the controller 60 by the processor 201 corresponds to execution of the control method.

As shown in FIG. 11, first, the controller 60 acquires information regarding the degree of temporary deterioration (step S301). As an example, the acquisition unit 61 of the present embodiment acquires the degree of temporary deterioration calculated by the monitor 50. The acquisition unit 61 acquires other battery information, flight information, weather information, and regulation information. That is, the controller 60 executes the processing shown in FIG. 11 in a period (timing) excluding the takeoff and landing times. The controller 60 executes processing, for example, at a cruise time or before takeoff described above.

Next, the controller 60 compares the acquired degree of temporary deterioration with a threshold Th3, and determines whether the degree of temporary deterioration is greater than the threshold Th3 (step S302). That is, the determination unit 62 determines necessity of execution of the recovery control. If the degree of temporary deterioration is equal to or less than the threshold Th3, the control unit 63 executes normal control (step S303). In the normal control, the control unit 63 executes the control without taking the degree of temporary deterioration into consideration. For example, the control unit 63 executes control for achieving the indicated flight state, for example, control of the rotor blade 13. The output unit 64 outputs the control signal (step S308), and ends the series of processing.

If the degree of temporary deterioration is greater than the threshold Th3 in step S302, the determination unit 62 determines whether the temperature of the target battery 151T is greater than a threshold Th4 (step S304). The target battery 151T is the battery 151 whose degree of temporary deterioration is greater than threshold Th3. When the battery temperature is equal to or less than the threshold Th4, the control unit 63 executes control of increasing the output of the target battery 151T so that the temperature of the target battery 151T rises (step S305). As an example, the control unit 63 of the present embodiment increases the output of the target battery 151T by increasing the rotation speed of the rotor blade 13 driven by the electric power of the target battery 151T. The output of the target battery 151T may be increased by drive of an auxiliary machine such as an air conditioner.

If the battery temperature is higher than the threshold Th4 in step S304, the control unit 63 executes restriction of takeoff and landing (step S306) and executes recovery control (step S307). By executing step S306, the control unit 63 prohibits takeoff and landing at the time of executing the recovery control. Steps S306 and S307 may be executed at substantially the same timing. In step S307, the control unit 63 executes at least one of temporarily reducing or stopping output of the target battery 151T, temporarily charging or charging-discharging the target battery 151T, and relaxing restraint of the battery cell 154 of the target battery 151T. In step S308, the control signal is output, and the series of processing is ended.

Note that steps S304 and S305 may be omitted in the processing shown in FIG. 11. The processing of step S306 may be omitted. For example, if the degree of temporary deterioration is greater than the threshold Th3, the control unit 63 may then execute the recovery control.

<Summary of Second Embodiment>

According to the controller 60 of the present embodiment, discharge and/or charge of the battery 151 is controlled based on the degree of temporary deterioration caused by the imbalance in ion concentration of the battery 151. That is, the discharge and/or charge of the battery is controlled after the degree of temporary deterioration is grasped. Therefore, it is possible to execute appropriate control leading to safety of flight. Therefore, the flight safety can be enhanced.

If the degree of temporary deterioration is greater than a predetermined reference, the control unit 63 of the controller 60 executes recovery control of performing control so as to reduce the degree of temporary deterioration of the target battery 151T. The control unit 63 does not execute the recovery control if the degree of temporary deterioration is equal to or less than the predetermined reference. Only if the degree of temporary deterioration is greater than the predetermined reference, recovery control is executed to reduce the degree of temporary deterioration. This can restrict a battery output abnormality at landing or takeoff times requiring high output.

The control unit 63 executes, as the recovery control, at least one of temporarily reducing or stopping output of the target battery 151T, temporarily charging or charging-discharging the target battery 151T, and temporarily relaxing the restraint state of the battery cell 154 of the target battery 151T. By executing these recovery controls, it is possible to reduce the degree of temporary deterioration as described above.

As an example, the control unit 63 of the present embodiment executes the recovery control in a period excluding takeoff and landing times. This can restrict a battery output abnormality at landing or takeoff times requiring high output.

As an example, the control unit 63 of the present embodiment restricts takeoff or landing at the time of executing the recovery control. During execution of the recovery control, the performance necessary for takeoff and landing cannot be secured. The flight restriction can increase safety.

As an example, the control unit 63 of the present embodiment executes the recovery control if the temperature of the target battery 151T is higher than a predetermined temperature, and executes the recovery control after the output of the target battery 151T is increased and the temperature becomes higher than the predetermined temperature if the temperature of the target battery 151T is equal to or lower than the predetermined temperature. Since the temperature is high, diffusibility of ions can be secured, and the effect of reducing the degree of temporary deterioration can be enhanced.

As an example, the control unit 63 of the present embodiment controls the drive of the rotor blade 13 to increase the output of the target battery 151T. Since the temperature of the target battery 151T rises due to self-heating, the control time can be shortened. A dedicated device for heating the battery becomes unnecessary.

The operation management system 40 of the present embodiment includes the monitor 50 and the controller 60. The monitor 50 acquires information regarding the battery 151 and calculates the degree of temporary deterioration caused by an imbalance in ion concentration of the battery 151. The controller 60 controls discharge and/or charge of the battery 151 based on the degree of temporary deterioration. In this manner, the degree of temporary deterioration can be monitored, and charge and discharge of the battery 151 can be controlled based on this monitoring result. Therefore, appropriate control leading to flight safety can be executed. Therefore, the flight safety can be enhanced.

The program (program 203P) of the present embodiment includes causing at least one processor 201 (processing unit) to acquire information regarding the degree of temporary deterioration caused by an imbalance in ion concentration of the battery 151 and to control discharge and/or charge of the battery 151 based on the degree of temporary deterioration. According to this program, it is possible to control discharge and/or charge of the battery 151 after grasping the degree of temporary deterioration. Therefore, appropriate control leading to flight safety can be executed. Therefore, the flight safety can be enhanced.

<Modification>

The configuration described in the present embodiment can be combined with the configuration described in the preceding embodiment.

While a combination of the monitor 50 and the controller 60 has been described, it is not limited to this. The controller 60 may be configured be included alone. For example, the controller 60 may have a function of estimating the degree of temporary deterioration, and the acquisition unit 61 may acquire the estimation result. The degree of temporary deterioration may be acquired from a functional unit different from the monitor 50.

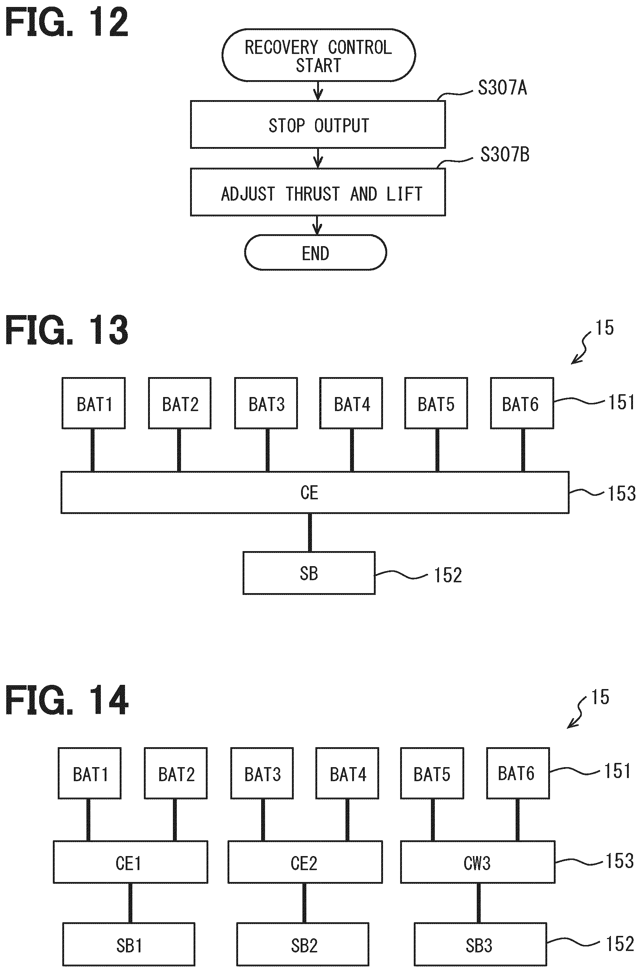

The recovery control in step S307 described above may be replaced with processing in FIG. 12. The control unit 63 first stops the output of the target battery 151T before executing the recovery control (step S307A). Next, the control unit 63 executes drive of the rotor blade 13 by the output of other batteries 151 except the target battery 151T whose output is stopped and lift adjustment of the lift adjustment mechanism 14. That is, the drive of the rotor blade 13 and the lift adjustment mechanism 14 is controlled to adjust thrust and lift necessary for flight (step S307B). This enables stable flight while reducing the degree of temporary deterioration of the target battery 151T.

(Third Embodiment)

This embodiment is a modification based on the preceding embodiment, and the description of the preceding embodiment can be incorporated. In the present embodiment, a configuration in which the degree of temporary deterioration can be reduced by charge or charge-discharge will be described.

<Battery System>

As illustrated in the preceding embodiment (see FIG. 4), the battery system 15 includes the battery 151, the auxiliary battery 152, and the charge-related equipment 153. The battery 151 supplies electric power to a drive target including the rotor blade 13. The battery 151 may be called a driving battery. The auxiliary battery 152 temporarily charges the battery 151 to reduce temporary deterioration of the battery 151. The battery 151 that is a target of charge is basically the target battery 151T described above, but it is also possible to charge the battery 151 whose degree of temporary deterioration does not exceed the threshold. Unlike normal power feeding, the auxiliary battery 152 is charged and operated for a short period of time with limited capacity and ΔSOC. Since the progress of recovery by the charge operation varies depending on the battery cell, the condition of the charge operation suitable for the battery cell to be used may be determined in advance by an experiment or the like. For example, ΔSOC is about 0.001% to 10%.

As described later, at least one of the batteries 151 other than the target battery 151T may be the auxiliary battery 152. The auxiliary battery 152 that supplies no electric power to a drive target including the rotor blade 13, that is, the auxiliary battery 152 different from the battery 151 may be provided. For example, this auxiliary battery 152 is used only for charging the battery 151. The auxiliary battery 152 provided separately from the battery 151 may have a smaller storage capacity than that of the battery 151. For example, a capacitor may be used.

The charge-related equipment 153 controls charge of the battery 151 from the auxiliary battery 152. As an example, the operation of the charge-related equipment 153 of the present embodiment is controlled by the controller 60. The charge-related equipment 153 at least has a function of electrically connecting or disconnecting the auxiliary battery 152 and the battery 151, that is, a function of turning on and off the connection, in order to manage the timing of charge operation and continuous operation time. The charge-related equipment 153 includes, for example, a relay in order to turn on and off the connection.

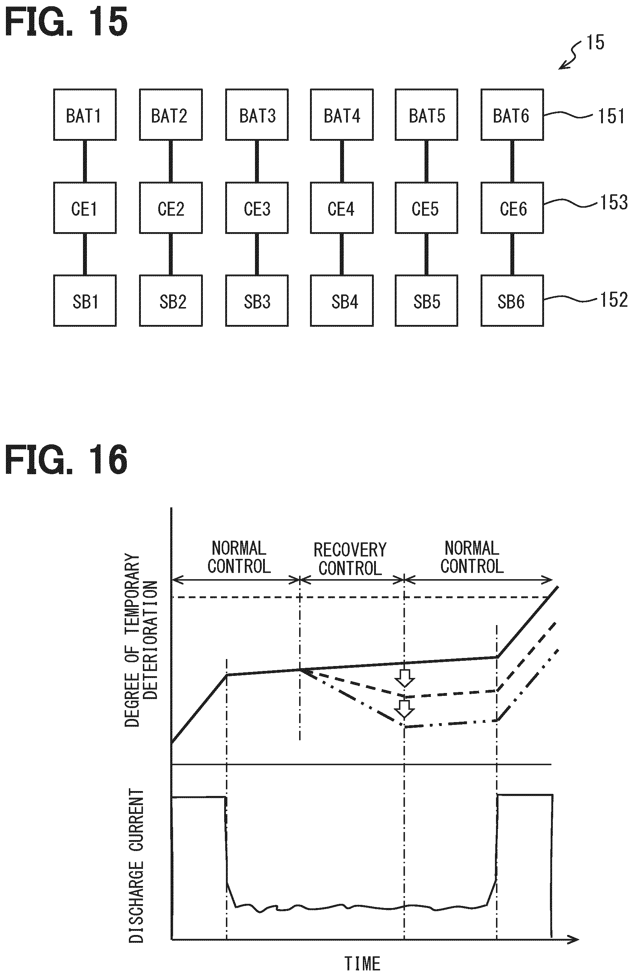

FIGS. 13, 14, and 15 illustrate configuration examples of the battery system 15. FIGS. 13 to 15 illustrate an example in which the auxiliary battery 152 is provided separately from the battery 151. As illustrated in FIG. 13, one piece of the charge-related equipment (CE) 153 may be provided for all the batteries (BAT) 151. As illustrated in FIG. 14, plural pieces of the charge-related equipment 153, the number of which is smaller than the number of the batteries 151, may be provided, and each piece of the charge-related equipment 153 may control the batteries 151. As illustrated in FIG. 15, the charge-related equipment 153 may be individually provided for the batteries 151. In any of the examples, the same number of auxiliary batteries (SB) 152 as the number of pieces of charge-related equipment 153 are provided. However, the auxiliary battery 152 may also be configured by connecting batteries in parallel and/or in series.

The battery system 15 can have various configurations in consideration of the arrangement of the batteries 151 in the eVTOL 10, for example, a concentrated arrangement of the batteries onto the airframe lower part, a distributed arrangement on the airframe or the fixed wing, and the like. Some or all of the batteries 151, the auxiliary battery 152, and the charge-related equipment 153 may be integrated (packaged) from the viewpoint of ease of handling and weight reduction such as reduction in the number of components and harness length.

The charge operation by the charge-related equipment 153 may be executed at the following timing. The charge-related equipment 153 may operate so as to charge the batteries 151, for example, the target battery 151T from the auxiliary battery 152 in a period except for takeoff and landing times. The charge-related equipment 153 may operate so as to prohibit electrical connection between the auxiliary battery 152 and the batteries 151 at takeoff and landing times. The charge-related equipment 153 may operate so as to charge the target battery 151T from the auxiliary battery 152 if the degree of temporary deterioration of the batteries 151 is greater than a predetermined reference.

Similarly to the preceding embodiment, the threshold value that is a predetermined reference may be set to a degree of temporary deterioration predicted to be unable to secure battery output characteristics required at landing or takeoff times. The threshold may be set in consideration of the effect of reducing the temporary deterioration due to the charge operation. A margin may be added to the threshold. The threshold may be changed over time based on the operation plan and the operation status of the present flight. The degree of temporary deterioration is not limited to timely information by monitoring of the monitor 50. The charge operation may be performed based on the operation plan and the history information of past flights. For example, when the temporary deterioration is assumed to be greater than a predetermined value based on the history information at a specific timing during operation, an operation may be performed to charge the battery.

As described in the preceding embodiment, when the battery temperature is high, ions are likely to diffuse. Therefore, if the temperature of the target battery 151T is higher than the predetermined temperature, the charge-related equipment 153 may operate so as to charge the target battery 151T from the auxiliary battery 152.

When the output (discharge current) is stopped, the concentration imbalance decreases as diffusion of ions progresses, and the degree of temporary deterioration can be reduced. Therefore, the charge-related equipment 153 may operate so as to charge the battery 151 from the auxiliary battery at the timing when the output of the battery 151 is stopped. As illustrated in FIG. 16, a higher reduction effect (recovery effect) can be obtained by the combination of the output stop and charge. In FIG. 16, the degree of temporary deterioration when the recovery control is executed is indicated by a broken line and a two-dot chain line. The broken line indicates a case of performing only output stop, and the two-dot chain line indicates a case of performing output stop and charge. A solid line indicates the degree of temporary deterioration in a case of executing the normal control also in the recovery control period.

The operation for charging by the charge-related equipment 153 may be performed continuously or intermittently. The charge operation time or the charge condition may be set based on the charge operation time or the charge condition obtained in advance by an experiment or the like and the effect thereof. The charge operation time or the charge condition may be set based on the past history information. An elimination effect, that is, the degree of temporary deterioration may be confirmed in real time, and the necessity of continuation of the charge operation may be determined.

The charge-related equipment 153 may additionally have another function to the function of turning on and off the connection described above, that is, turning on and off the energization. The charge-related equipment 153 may have a function of adjusting the current when, for example, the battery 151 is charged from the auxiliary battery 152. The charge-related equipment 153 may have a function of distributing the current when the batteries 151 are charged from the auxiliary battery 152. The charge-related equipment 153 may have a function of performing bidirectional charge between the auxiliary battery 152 and the battery 151.

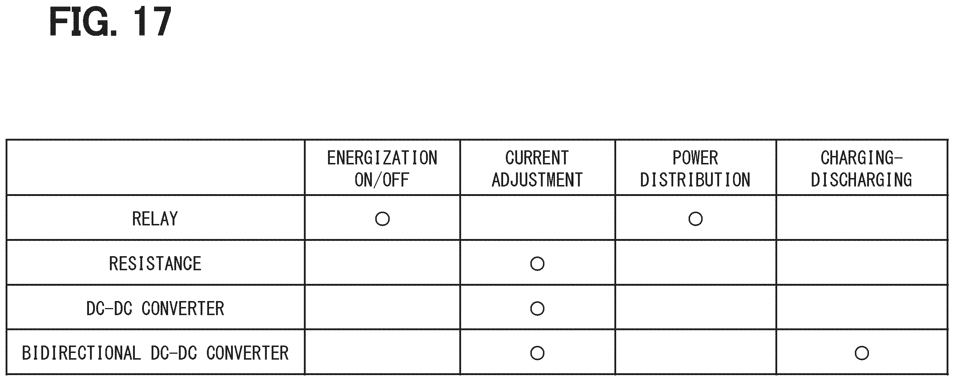

FIG. 17 illustrates functions required for the charge-related equipment 153. When it is necessary to control the current, a current adjustment function may be added. For example, resistance, a DC-DC converter, a bidirectional DC-DC converter, or the like can be used. In the case of charging the batteries 151, a power distribution function may be added. For example, a relay can be used. In a case where it is desired to add a bidirectional charge function, for example, a bidirectional DC-DC converter can be used. The DC-DC converter can increase the voltage, and the DC-DC converter can increase and decrease the voltage.

As described above, among the batteries 151, at least one of other batteries 151 except for the target battery 151T may be used as the auxiliary battery 152. That is, the charge-related equipment 153 may operate so as to charge the target battery 151T, which is another battery 151, from the auxiliary battery 152, which is a part of the batteries 151. This eliminates the need for providing the auxiliary battery 152 that supplies no electric power to the drive target such as the rotor blade 13 separately from the battery 151.

In the configuration in which the temporary deterioration is reduced by interchanging the power among the batteries 151, the charge-related equipment 153 may operate so as to charge the battery 151 having a low voltage from the battery 151 having a high voltage. The charge-related equipment 153 may manage the order of charge operation so as to charge from the battery 151 having a larger degree of temporary deterioration. The battery 151 recovered by charge may be used as the auxiliary battery 152, and the order of charge operation may be managed so as to charge the other batteries 151.

For example, when the voltage of the battery 151 that is a charge target is lower than that of the battery 151 that is the auxiliary battery 152, the charge-related equipment 153 may operate so as to charge the battery 151 from the auxiliary battery 152. For example, when the degree of temporary deterioration of other battery 151 is greater than that of the battery 151 that is the auxiliary battery 152, the charge-related equipment 153 may operate so as to charge the other batteries 151 from the auxiliary battery 152.

For example, the charge-related equipment 153 may operate such that the battery 151 serves as the auxiliary battery 152 after the battery 151 is recovered by charge. The battery 151 that has been the auxiliary battery 152 may be operated so as to be recovered by a new auxiliary battery 152. For example, the charge-related equipment 153 may operate so as to select and charge a combination of the battery 151 to serve as the auxiliary battery 152 and at least one battery 151 to be charged such that at least some of the batteries 151 can be recovered by charge.

<Control Device>

The configuration of the controller 60 is similar to that of the preceding embodiment (see FIG. 8). The control unit 63 executes control of temporarily charging or charging-discharging the target battery 151T as the recovery control executed in step S307.

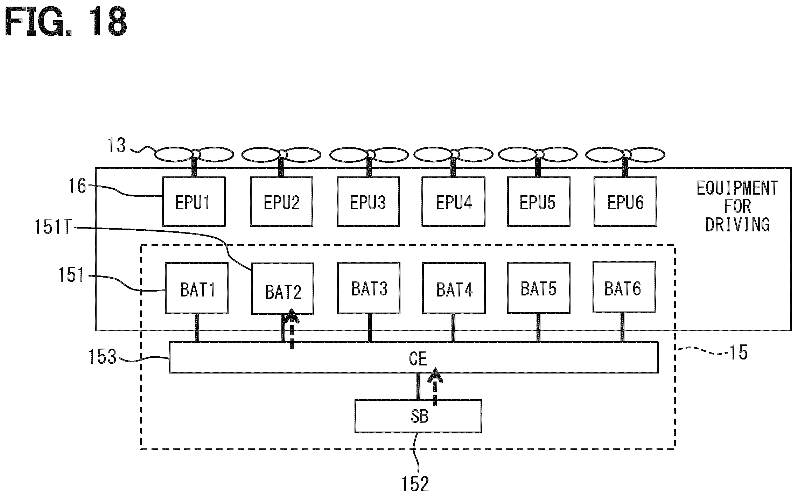

For example, as illustrated in FIG. 18, when the battery system 15 includes the auxiliary battery 152 separately from the battery 151, the control unit 63 may control the auxiliary battery 152 to charge the target battery 151T. By this, the charge-related equipment 153 operates so as to charge the target battery 151T from the auxiliary battery 152. The charge-related equipment 153 electrically connects the auxiliary battery 152 and the target battery 151T. The charge-related equipment 153 performs current adjustment, power distribution, charge-discharge, and the like as necessary.

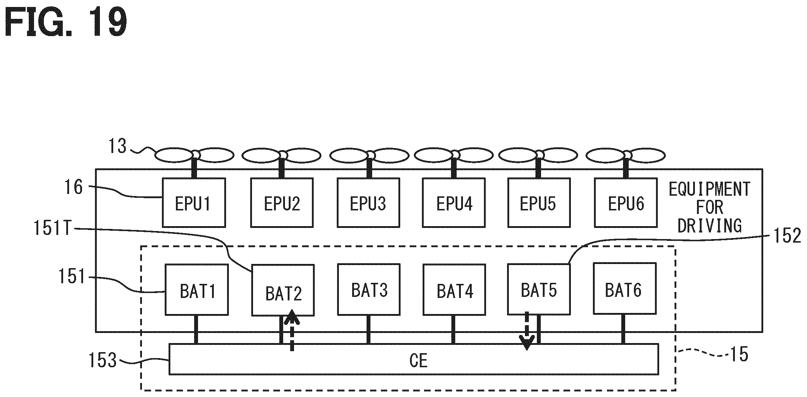

For example, as illustrated in FIG. 19, when the auxiliary battery 152 different from the battery 151 is not included, the control unit 63 may perform control such that at least one of other batteries 151 except the target battery 151T is charged as the auxiliary battery 152 to the target battery 151T. In FIG. 19, as an example, the battery (BAT5) 151 having a voltage exceeding that of the target battery 151T is assumed to be the auxiliary battery 152. The charge-related equipment 153 operates so as to charge the target battery (BAT2) 151T from the battery (BAT5) 151 that is the auxiliary battery 152. The charge-related equipment 153 electrically connects the auxiliary battery (BAT5) 152 and the target battery (BAT2) 151T. The charge-related equipment 153 performs current adjustment, power distribution, charge-discharge, and the like as necessary.

The control unit 63 may perform control so as to charge from other batteries 151 having a voltage exceeding that of the target battery 151T The above control can be executed based on the voltage of the battery 151. The control unit 63 may prohibit, at takeoff and landing times, turning on of the relay for electrically connecting the equipment for charging or charging-discharging and the target battery 151T. The control unit 63 may output a prohibition signal to the charge-related equipment 153 along with executing the processing of step S306. By this, turning on of the relay included in the charge-related equipment 153 is prohibited.

Other configurations of the controller 60 are similar to those described in the second embodiment. The configuration of the operation management system 40 is also similar to that of the second embodiment.

<Summary of Third Embodiment>

According to the controller 60 of the present embodiment, in the configuration including the auxiliary battery 152 separately from the battery 151 that drives the drive target, the auxiliary battery 152 charges the target battery 151T when the recovery control of temporarily charging or charging-discharging the target battery 151T is executed. Since the auxiliary battery 152 different from the battery 151 is used, a load on the battery 151 can be reduced. The weight can be reduced as compared with a generator, a fuel cell, and the like. If it is dedicated to charge, the capacity can be reduced, and therefore it is possible to reduce the size and weight. The charge timing is not limited as in power regeneration. $CO_2$ emission can be suppressed as compared with a generator.

When executing recovery control of temporarily charging or charging-discharging the target battery 151T, the controller 60 charges the target battery 151T from other batteries 151 except for the target battery 151T. This eliminates the need for the auxiliary battery 152 dedicated to charge and a generator. In the configuration in which some of the batteries 151 are used as the auxiliary battery 152 in this manner, the controller 60 may charge from other batteries 151 having a voltage exceeding that of the target battery 151T. This eliminates the need for a boost converter. Therefore, the configuration of the charge-related equipment 153 can be simplified.

When executing recovery control of temporarily charging or charging-discharging the target battery 151T, the controller 60 may prohibit, at takeoff and landing times, turning on of the relay for electrically connecting the equipment for charging or charging-discharging and the target battery 151T. This can suppress unexpected charge or charge-discharge from occurring at takeoff and landing times and from affecting the takeoff and landing operations. Therefore, the flight safety can be enhanced.

The battery system 15 according to the present embodiment includes the battery 151 (driving battery) that supplies power to a drive target including the rotor blade 13, the auxiliary battery 152 that charges the battery, and the charge-related equipment 153 that controls charge from the auxiliary battery 152 to the battery 151. The charge-related equipment 153 has a function of electrically connecting or disconnecting the auxiliary battery 152 and the battery 151.

Since concentration imbalance occurs due to discharge during flight, a concentration imbalance can be reduced and temporary deterioration can be reduced by temporarily charging and changing the orientation of the current. By charging the battery 151 from the auxiliary battery 152, recovery of temporary deterioration can be promoted during flight, particularly at a cruise time. This can restrict in advance a battery output abnormality at the time point of landing requiring high output. Similarly, it is possible to restrict in advance a battery output abnormality at the time point of takeoff requiring high output. That is, the flight safety can be enhanced.

The charge-related equipment 153 may operate so as to charge the battery 151 from the auxiliary battery 152 in a period (timing) excluding takeoff and landing times. The temporary deterioration is eliminated or reduced by performing a charge operation at a timing excluding takeoff and landing times. Therefore, it is possible to more reliably restrict in advance a battery output abnormality at takeoff and landing times.

The charge-related equipment 153 may operate so as to prohibit electrical connection between the auxiliary battery 152 and the batteries 151 at takeoff and landing times. The safety of the system can be enhanced by prohibiting electrical connection except for the timing of performing the charge operation.

The charge-related equipment 153 may operate so as to charge the target battery 151T from the auxiliary battery 152 if the degree of temporary deterioration of the driving battery is greater than the predetermined reference (threshold Th3). By performing the charge operation when the degree of temporary deterioration is greater than the predetermined reference, the degree of temporary deterioration can be reduced at an appropriate timing. As a result, it is possible to restrict in advance a battery output abnormality at landing or takeoff times requiring high output.

The charge-related equipment 153 may operate so as to charge the target battery 151T from the auxiliary battery 152 if the temperature of the target battery 151T is higher than the predetermined temperature (threshold Th4). As described above, when the temperature of the target battery 151T is high, ions are likely to diffuse. Therefore, by performing the charge operation when the temperature is higher than the predetermined temperature, the diffusibility of ions can be secured, and eventually, the effect of reducing the degree of one deterioration (recovery effect) can be enhanced.

The charge-related equipment 153 may operate so as to charge the battery 151 from the auxiliary battery 152 at a timing when the output of the batteries 151 is stopped. The combination of output stop and charge can give a higher recovery effect as illustrated in FIG. 16.

The charge-related equipment 153 may have a function of adjusting the current when the battery 151 is charged from the auxiliary battery 152. This can restrict occurrence of an equipment abnormality due to overcurrent. That is, the safety can be enhanced. The deterioration of the battery 151 can be suppressed by the current restriction. For example, use of a DC-DC converter enables the battery 151 to be charged from the auxiliary battery 152 even if the voltage of the auxiliary battery 152 is low.

The charge-related equipment 153 may have a function of distributing the current when the batteries 151 are charged from the auxiliary battery 152. By having a function of power distribution, it is possible to simultaneously charge the batteries 151 and efficiently execute the recovery control.

The charge-related equipment 153 may operate so as to bidirectionally charge between the auxiliary battery 152 and the battery 151. This makes it easy to use a small-capacity, small-sized battery as the auxiliary battery 152. When the SOC of auxiliary battery 152 decreases, it can be charged from the battery 151. For example, use of a bidirectional DC-DC converter enables recovery control by charge-discharge.

The charge-related equipment 153 may operate so as to charge other batteries 151 from the auxiliary battery 152 that is a part of the batteries 151. This can eliminate the need for the auxiliary battery 152 dedicated to charge. In this configuration, when the voltage of the battery 151 is lower than that of the auxiliary battery 152, the charge-related equipment 153 may operate so as to charge the battery 151 from the auxiliary battery 152. This enables charge without requiring a boost converter. The charge-related equipment 153 can be simplified.

The auxiliary battery 152 is set to have a smaller storage capacity than that of the battery 151, and may be provided so as not to be able to supply power to the drive target. The auxiliary battery 152 provided separately from the battery 151 can be reduced in size and weight.

<Modification>

The configuration described in the present embodiment can be combined with the configuration described in the preceding embodiment. For example, combination with the monitor 50 described in the first embodiment is possible.

While a combination of the monitor 50 and the controller 60 has been described, it is not limited to this. While the combination of the controller 60 and the battery system 15 has been described, it is not limited to this. The controller 60 may be configured be included alone. The battery system 15 may be configured be included alone.

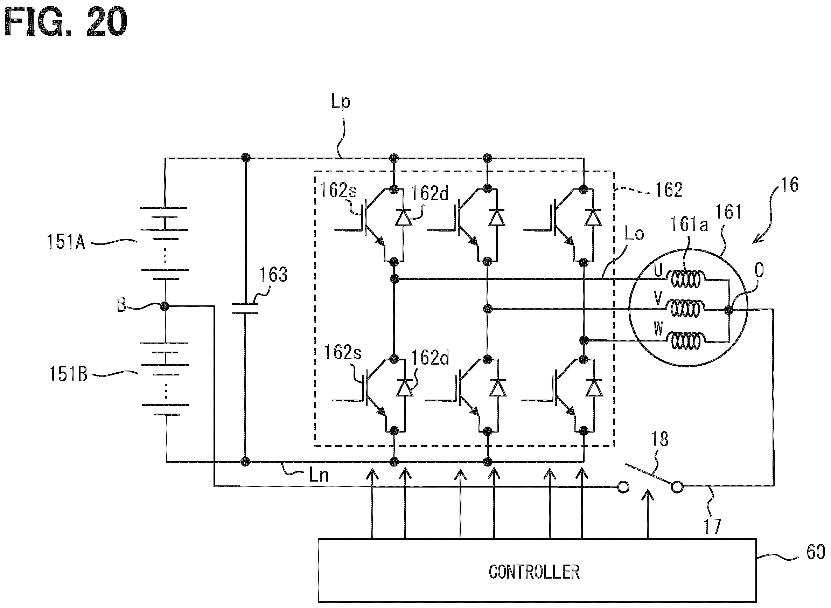

An example in which the power of the battery 151 is interchanged via the charge-related equipment 153 has been described, but it is not limited to this. For example, as illustrated in FIG. 20, the power of the battery 151 may be interchanged via a motor 161 and an inverter 162 constituting the EPU 16. The EPU 16 includes a smoothing capacitor 163 in addition to the motor 161 and the inverter 162. In FIG. 20, for simplification, the battery system 15 is configured to include two batteries 151A and 151B, and the batteries 151A and 151B are connected in series to constitute a direct-current power source. The smoothing capacitor 163 is connected in parallel to the direct-current power source. A positive electrode of the smoothing capacitor 163 is connected to a positive electrode line Lp connected to the positive electrode of the direct-current power source. A negative electrode of the smoothing capacitor 163 is connected to a negative electrode line Ln connected to the negative electrode of the direct-current power source.

Each of upper and lower arm circuits for three phases constituting the inverter 162 is configured by directly connecting a switching element 162s. FIG. 20 illustrates an example of an IGBT as the switching element 162s. The IGBT is an abbreviation for insulated gate bipolar transistor. A MOSFET may be employed in place of the IGBT. The MOSFET is an abbreviation for metal oxide semiconductor field effect transistor. A collector of the switching element 162s on the upper arm side is connected to the positive electrode line Lp, and an emitter of the switching element 162s on the lower arm side is connected to the negative electrode line Ln. A diode 162d for reflux is connected in anti-parallel to each of the switching elements 162s. An anode of the diode 162d is connected to the emitter, and a cathode is connected to the collector.

The connection point of each of the upper and lower arm circuits is connected to a winding 161a of the motor 161 via a corresponding output line Lo. The upper and lower arm circuits of the U-phase are connected to the winding 161a of the U-phase via the corresponding output lines Lo. The upper and lower arm circuits of the V-phase are connected to the winding 161a of the V-phase via the corresponding output lines Lo. The upper and lower arm circuits of the W-phase are connected to the winding 161a of the W-phase via the corresponding output lines Lo. The connection route 17 electrically connects a neutral point O of the motor 161, which is the connection point of the windings 161a of the three phases, and a connection point B of the batteries 151A and 151B. The connection route 17 is provided with a connection switch 18. When the connection switch 18 is turned on, the neutral point O and the connection point B are electrically connected. When the connection switch 18 is turned off, the neutral point O and the connection point B are electrically disconnected from each other.

In the above configuration, the controller 60 controls the switching element 162s and the connection switch 18 such that the current flows between the battery 151A and the battery 151B via the inverter 162, the winding 161a, and the connection route 17. The controller 60 turns on the connection switch 18, for example, synchronizes the switching elements 162s on the upper arm side with each other, and synchronizes the switching elements 162s on the lower arm side with each other. For example, when the switching element 162s on the upper arm side is turned on, the switching element 162s on the lower arm side is turned off. Therefore, it is possible to interchange power between the batteries 151A and 151B. Via the elements of the EPU 16, the target battery 151T can be charged from one of the batteries 151, which is the auxiliary battery 152.

FIG. 20 illustrates an example in which the controller 60 controls the switching elements 162s and the connection switch 18, but it is not limited to this. The battery system 15 may be configured to include a part of the connection route 17 and the connection switch 18.

(Other Embodiments)

The disclosure in this description, drawings, and the like is not restricted to the illustrated embodiments. The disclosure includes the illustrated embodiments and modifications based thereon by those skilled in the art. For example, the disclosure is not limited to the combinations of components and/or elements shown in the embodiments. The disclosure can be performed by various combinations. The disclosure can have additional parts that can be added to the embodiments. The disclosure encompasses those in which components and/or elements of the embodiments are omitted. The disclosure encompasses replacement or combination of components and/or elements between one embodiment and another embodiment. The disclosed technical scope is not limited to the description of the embodiments. The several technical scopes disclosed are indicated by the description of the claims, and should be further understood to include meanings equivalent to the description of the claims and all modifications within the scope.

The disclosure in the description, the drawings, and the like is not limited by the description of the claims. The disclosure in the description, the drawings, and the like includes the technical idea described in the claims, and further covers a wider variety of technical ideas than the technical idea described in the claims. Therefore, various technical ideas can be extracted from the disclosure of the description, the drawings, and the like without being restrained by the description of the claims.

When an element or layer is mentioned to be "on", "coupled", "connected", or "joined", it may be directly on, coupled, connected, or joined to another element or another layer, and further an intervening element or an intervening layer may exist. In contrast, when an element is mentioned to be "directly on", "directly coupled to", "directly connected to", or "directly joined to" another element or layer, there are no intervening elements and no intervening layers exist. Other words used to describe the relationship among elements should be interpreted in a similar fashion (e.g., "between" versus "directly between", "adjacent" versus "directly adjacent", and the like). In a case of being used in this description, the term "and/or" includes any and all combinations of one or plural associated listed items.

Each of the various flowcharts shown in the present disclosure is an example, and the number of steps constituting the flowchart and the execution order of the processing can be appropriately changed. The devices, the systems, and the techniques thereof described in the present disclosure may be implemented by a dedicated computer constituting a processor programmed so as to execute one or plural functions embodied by a computer program. The devices and the techniques thereof described in the present disclosure may be implemented using a dedicated hardware logic circuit. Furthermore, the devices and the techniques thereof described in the present disclosure may be implemented by one or more dedicated computers configured by a combination of a processor that executes a computer program and one or more hardware logic circuits.

For example, some or all of the functions included in the processor 201 may be implemented as hardware. Aspects in which a certain function is implemented as hardware include an aspect in which the certain function is implemented using one or plural ICs or the like. As the processor (arithmetic core), a CPU, an MPU, a GPU, a DFP, or the like can be employed. CPU is an abbreviation for central processing unit. MPU is an abbreviation for micro-processing unit. GPU is an abbreviation for graphics processing unit. DFP is an abbreviation for data flow processor.

Some or all of the functions included in the processor 201 may be implemented by combining plural types of arithmetic processing devices. Some or all of the functions of the processor 201 may be implemented by using a SoC, an ASIC, an FPGA, or the like. SoC is an abbreviation for system on chip. ASIC is an abbreviation for application specific integrated circuit. FPGA is an abbreviation for field-programmable gate array. The same applies to the processor 311.

A computer program may be stored in a computer-readable non-transitory tangible storage medium as an instruction executed by a computer. As a storage medium of the program, an HDD, an SSD, a flash memory, or the like can be employed. HDD is an abbreviation for hard-disk drive. SSD is an abbreviation for solid state drive. The scope of the present disclosure also includes a program for causing a computer to function as the monitor 50 or the controller 60, and forms such as a non-transitory tangible storage medium such as a semiconductor memory in which the program is stored.

(Disclosure of Technical Idea)

This description discloses multiple technical ideas described in multiple items listed below. Some items may be written in a multiple dependent form with subsequent items referring to the preceding item as an alternative. Some items may be written in a multiple dependent form referring to another multiple dependent form. These sections written in the multiple dependent form define a plurality of technical ideas.

<Technical Idea 1>

A monitor configured to monitor a state of a battery (151) mounted on an electric aircraft (10), the monitor includes:

an acquisition unit (51) configured to acquire information regarding the battery;
a calculation unit (52) configured to calculate, based on the information, a degree of temporary deterioration caused by an imbalance in ion concentration of the battery; and
an output unit (54) configured to output information regarding the degree of temporary deterioration.

<Technical Idea 2>

In the monitor according to Technical Idea 1, the calculation unit is configured to calculate the degree of temporary deterioration by a predetermined period before start of landing at a cruise time of the electric aircraft and/or by a predetermined period before start of takeoff of the electric aircraft.

<Technical Idea 3>

In the monitor according to Technical Idea 2, the predetermined period is set based on a period necessary for processing to reduce the degree of temporary deterioration.

<Technical Idea 4>

In the monitor according to any one of Technical Ideas 1 to 3, the calculation unit is configured to calculate the degree of temporary deterioration based on a discharge history or a charge-discharge history of the battery during a flight.

<Technical Idea 5>

In the monitor according to any one of Technical Ideas 1 to 3, the calculation unit is configured to calculate the degree of temporary deterioration based on resistance of the battery.

<Technical Idea 6>

In the monitor according to Technical Idea 5, the calculation unit is configured to calculate the degree of temporary deterioration based on a resistance component of alternating-current impedance of the battery.

<Technical Idea 7>

In the monitor according to any one of Technical Ideas 1 to 3, the calculation unit is configured to calculate the degree of temporary deterioration based on information on battery states of a target flight and a past flight in which a model and a takeoff point and/or a landing point match.

<Technical Idea 8>

The monitor according to any one of Technical Ideas 1 to 7 further includes: a determination unit (53) configured to determine necessity of a takeoff restriction or a landing restriction of the electric aircraft based on the degree of temporary deterioration, and the output unit is configured to output information regarding necessity.

<Technical Idea 9>

The monitor according to any one of Technical Ideas 1 to 7 further includes: a determination unit (53) configured to determine necessity of maintenance of the battery based on the degree of temporary deterioration, and the output unit is configured to output information regarding necessity.

<Technical Idea 10>

In the monitor according to Technical Idea 8 or 9, a threshold used for necessity determination by the determination unit is set based on history information of a target flight and a past flight in which a takeoff point and/or a landing point and a model match.

<Technical Idea 11>

A controller for an electric aircraft (10) that drives a drive target including a rotor blade (13) by a plurality of batteries (151), the controller includes:

an acquisition unit (61) configured to acquire information regarding a degree of temporary deterioration caused by an imbalance in ion concentration of the batteries; and
a control unit (62) configured to control discharge and/or charge of the batteries based on the degree of temporary deterioration.

<Technical Idea 12>

In the controller according to Technical Idea 11,

the control unit is configured to execute recovery control of performing control so as to reduce a degree of temporary deterioration of a target battery when the degree of temporary deterioration is greater than a predetermined reference, and
the control unit is configured to not execute the recovery control when the degree of temporary deterioration is equal to or less than a predetermined reference.

<Technical Idea 13>

In the controller according to Technical Idea 12, the control unit is configured to execute, as the recovery control, at least one of temporarily reducing or stopping output of the target battery, temporarily charging or charging-discharging the target battery, and temporarily relaxing a restraint state of a battery cell of the target battery.

<Technical Idea 14>

In the controller according to Technical Idea 12 or 13, the control unit is configured to perform the recovery control in a period excluding a time of takeoff and a time of landing.

<Technical Idea 15>

In the controller according to any one of Technical Ideas 12 to 14, the control unit is configured to restrict takeoff or landing when executing the recovery control.

<Technical Idea 16>

In the controller according to any one of Technical Ideas 12 to 15, the control unit is configured to execute the recovery control in a case where a temperature of the target battery is higher than a predetermined temperature, and is configured to execute the recovery control after an output of the target battery is increased and the temperature exceeds the predetermined temperature in a case where the temperature of the target battery is equal to or lower than the predetermined temperature.

<Technical Idea 17>

In the controller according to Technical Idea 16, the control unit is configured to increase output of the target battery by controlling drive of the rotor blade.

<Technical Idea 18>

In the controller according to Technical Idea 13, the electric aircraft includes the rotor blade that generates rotary lift, a fixed wing (12) that generates gliding lift, and a lift adjustment mechanism (14) that adjusts the gliding lift, and
when executing the recovery control for stopping the output of the target battery, the control unit secures thrust and lift necessary for flight by drive of the rotor blade by an output of an other of the batteries except the target battery whose output is stopped and by lift adjustment of the lift adjustment mechanism.

<Technical Idea 19>

In the controller according to Technical Idea 13, the electric aircraft includes an auxiliary battery (152) separately from the batteries that drive the drive target, and
the control unit is configured to charge the target battery from the auxiliary battery when executing the recovery control of temporarily charging or charging-discharging the target battery.

<Technical Idea 20>

In the controller according to Technical Idea 13, the control unit is configured to charge the target battery from an other of the batteries except the target battery when executing the recovery control of temporarily charging or charging-discharging the target battery.

<Technical Idea 21>

In the controller according to Technical Idea 20, the control unit is configured to perform charging from an other of the batteries having a voltage exceeding a voltage of the target battery.

<Technical Idea 22>

In the controller according to any one of Technical Ideas 19 to 21, the control unit is configured to prohibit, at takeoff and landing times, turning on of a relay (153) for electrically connecting equipment for charging or charging-discharging and the target battery when executing the recovery control of temporarily charging or charging-discharging the target battery.

**Claims**

1. A monitor configured to monitor a state of a battery (151) mounted on an electric aircraft (10), the monitor comprising:

   an acquisition unit (51) configured to acquire information regarding the battery;
   a calculation unit (52) configured to calculate, based on the information, a degree of temporary deterioration caused by an imbalance in ion concentration of the battery; and
   an output unit (54) configured to output information regarding the degree of temporary deterioration.

2. The monitor according to claim 1, wherein the calculation unit is configured to calculate the degree of temporary deterioration by a predetermined period before start of landing at a cruise time of the electric aircraft and/or by a predetermined period before start of takeoff of the electric aircraft.

3. The monitor according to claim 2, wherein the predetermined period is set based on a period necessary for processing to reduce the degree of temporary deterioration.

4. The monitor according to claim 1, wherein the calculation unit is configured to calculate the degree of temporary deterioration based on a discharge history or a charge-discharge history of the battery during a flight.

5. The monitor according to claim 1, wherein the calculation unit is configured to calculate the degree of temporary deterioration based on resistance of the battery.

6. The monitor according to claim 5, wherein the calculation unit is configured to calculate the degree of temporary deterioration based on a resistance component of alternating-current impedance of the battery.

7. The monitor according to claim 1, wherein the calculation unit is configured to calculate the degree of temporary deterioration based on information on battery states of a target flight and a past flight in which a model and a takeoff point and/or a landing point match.

8. The monitor according to claim 1 comprising: a determination unit (53) configured to determine necessity of a takeoff restriction or a landing restriction of the electric aircraft based on the degree of temporary deterioration, wherein the output unit is configured to output information regarding necessity.

9. The monitor according to claim 1 comprising: a determination unit (53) configured to determine necessity of maintenance of the battery based on the degree of temporary deterioration, wherein the output unit is configured to output information regarding necessity.

10. The monitor according to claim 8 or 9, wherein a threshold used for necessity determination by the determination unit is set based on history information of a target flight and a past flight in which a takeoff point and/or a landing point and a model match.

11. A controller for an electric aircraft (10) that drives a drive target including a rotor blade (13) by a plurality of batteries (151), the controller comprising:

an acquisition unit (61) configured to acquire information regarding a degree of temporary deterioration caused by an imbalance in ion concentration of the batteries; and a control unit (62) configured to control discharge and/or charge of the batteries based on the degree of temporary deterioration.

12. The controller according to claim 11, wherein

the control unit is configured to execute recovery control of performing control so as to reduce a degree of temporary deterioration of a target battery when the degree of temporary deterioration is greater than a predetermined reference, and the control unit is configured to not execute the recovery control when the degree of temporary deterioration is equal to or less than a predetermined reference.

13. The controller according to claim 12, wherein the control unit is configured to execute, as the recovery control, at least one of temporarily reducing or stopping output of the target battery, temporarily charging or charging-discharging the target battery, and temporarily relaxing a restraint state of a battery cell of the target battery.

14. The controller according to claim 12 or 13, wherein the control unit is configured to perform the recovery control in a period excluding a time of takeoff and a time of landing.

15. The controller according to claim 12 or 13, wherein the control unit is configured to restrict takeoff or landing when executing the recovery control.

16. The controller according to claim 12 or 13, wherein the control unit is configured to execute the recovery control in a case where a temperature of the target battery is higher than a predetermined temperature, and is configured to execute the recovery control after an output of the target battery is increased and the temperature exceeds the predetermined temperature in a case where the temperature of the target battery is equal to or lower than the predetermined temperature.

17. The controller according to claim 16, wherein the control unit is configured to increase output of the target battery by controlling drive of the rotor blade.

18. The controller according to claim 13, wherein the electric aircraft includes the rotor blade that generates rotary lift, a fixed wing (12) that generates gliding lift, and a lift adjustment mechanism (14) that adjusts the gliding lift, and when executing the recovery control for stopping the output of the target battery, the control unit secures thrust and lift necessary for flight by drive of the rotor blade by an output of an other of the batteries except the target battery whose output is stopped and by lift adjustment of the lift adjustment mechanism.

19. The controller according to claim 13, wherein the electric aircraft includes an auxiliary battery (152) separately from the batteries that drive the drive target, and
the control unit is configured to charge the target battery from the auxiliary battery when executing the recovery control of temporarily charging or charging-discharging the target battery.

20. The controller according to claim 13, wherein the control unit is configured to charge the target battery from an other of the batteries except the target battery when executing the recovery control of temporarily charging or charging-discharging the target battery.

21. The controller according to claim 20, wherein the control unit is configured to perform charging from an other of the batteries having a voltage exceeding a voltage of the target battery.

22. The controller according to any one of claims 19 to 21, wherein the control unit is configured to prohibit, at takeoff and landing times, turning on of a relay (153) for electrically connecting equipment for charging or charging-discharging and the target battery when executing the recovery control of temporarily charging or charging-discharging the target battery.

23. An operation management system for an electric aircraft (10), the operation management system comprising:

   a monitor (50) configured to acquire information regarding a battery mounted on the electric aircraft and calculate a degree of temporary deterioration caused by an imbalance in ion concentration of the battery; and
   a controller (60) configured to control discharge and/or charge of the battery based on the degree of temporary deterioration.

24. A program for monitoring a state of a battery (151) mounted on an electric aircraft (10), the program comprising

   causing at least one processing unit (201)
   to acquire information regarding the battery, and
   to calculate a degree of temporary deterioration caused by an imbalance in ion concentration of the battery based on the information.

25. A program for controlling a battery (151) mounted on an electric aircraft (10), the program comprising

   causing at least one processing unit (201)
   to acquire information regarding a degree of temporary deterioration caused by an imbalance in ion concentration of the battery, and
   to control discharge and/or charge of the battery based on the degree of temporary deterioration.

**FIG. 1**

FIG. 2

# FIG. 3

EP 4 624 333 A1

# FIG. 4

# FIG. 5

# FIG. 6

# FIG. 7

```
        ┌──────────────────┐
        │  MONITOR         │
        │  START           │
        └────────┬─────────┘
                 │                          S201
        ┌────────▼─────────────────┐
        │  ACQUIRE INFORMATION     │
        └────────┬─────────────────┘
                 │                          S202
        ┌────────▼──────────────────────┐
        │ CALCULATE DEGREE OF TEMPORARY  │
        │ DETERIORATION                  │
        │  ・CURRENT HISTORY             │
        │  ・INTERNAL RESISTANCE         │
        │  ・PAST INFORMATION            │
        └────────┬───────────────────────┘
                 │                          S203
        ┌────────▼─────────────────┐
        │       SET Th1            │
        └────────┬─────────────────┘
                 │                          S204
            ╱────▼────────────────────╲
           ╱   DEGREE OF                ╲      NO
          ╱ TEMPORARY DETERIORATION >    ╲──────────────┐
           ╲       Th1 ?                 ╱               │
            ╲───────┬────────────────────╱              │
                    │ YES        S205                    │  S206
        ┌───────────▼──────────────┐      ┌─────────────▼───────────────┐
        │ RESTRICTION IS NECESSARY │      │ RESTRICTION IS UNNECESSARY  │
        └───────────┬──────────────┘      └─────────────┬───────────────┘
                    │◄─────────────────────────────────┘
                    │                          S207
        ┌───────────▼──────────────┐
        │         OUTPUT           │
        └───────────┬──────────────┘
                    │
           ┌────────▼─────────┐
           │       END        │
           └──────────────────┘
```

# FIG. 8

```
        ┌─────────────────┐
        │     MONITOR      │
        │      START       │
        └────────┬────────┘
                 │                    ╭─ S201
        ┌────────▼─────────────────┐
        │   ACQUIRE INFORMATION    │
        └────────┬─────────────────┘
                 │                    ╭─ S202
        ┌────────▼─────────────────┐
        │ CALCULATE DEGREE OF      │
        │ TEMPORARY DETERIORATION  │
        │  · CURRENT HISTORY       │
        │  · INTERNAL RESISTANCE   │
        │  · PAST INFORMATION      │
        └────────┬─────────────────┘
                 │                    ╭─ S203A
        ┌────────▼─────────────────┐
        │        SET Th2           │
        └────────┬─────────────────┘
                 │         S204A
              ◇──▼──────────────────◇
              │    DEGREE OF         │  NO
              │ TEMPORARY            ├────────────┐
              │ DETERIORATION > Th2 ?│            │
              ◇─────────┬───────────◇            │
                 │ YES                            │
                 │        S205A                   │  S206A
        ┌────────▼─────────────────┐   ┌──────────▼──────────────────┐
        │ MAINTENANCE IS NECESSARY │   │ MAINTENANCE IS UNNECESSARY  │
        └────────┬─────────────────┘   └──────────┬──────────────────┘
                 │◄──────────────────────────────┘
                 │                    ╭─ S207
        ┌────────▼─────────────────┐
        │        OUTPUT            │
        └────────┬─────────────────┘
                 │
        ┌────────▼─────────┐
        │       END        │
        └──────────────────┘
```

# FIG. 9

EQUIPMENT FOR DRIVING

13

16 — EPU1 | EPU2 | EPU3 | EPU4 | EPU5 | EPU6

151T

151 — BAT1 | BAT2 | BAT3 | BAT4 | BAT5 | BAT6

CHARGE-RELATED EQUIPMENT

AUXILIARY BATTERY

15

INFOR-MATION

51 · 50 · 54 · 152 · 62 · 153 · INSTRUC-TIONS · 60

FLIGHT INFORMATION
WEATHER INFORMATION
REGULATION INFORMATION

ACQUISITION UNIT

OUTPUT UNIT — 64

52 — CALCULATION UNIT

OUTPUT UNIT

DETERMINATION UNIT

CONTROL UNIT — 63

53 — DETERMINATION UNIT

ACQUISITION UNIT

61

MONITOR

CONTROLLER

70 — DISPLAY DEVICE

OPERATION MANAGEMENT SYSTEM — 40

EP 4 624 333 A1

# FIG. 10

# FIG. 11

CONTROL START

ACQUIRE INFORMATION — S301

DEGREE OF TEMPORARY DETERIORATION > Th3 ? — S302
- NO → NORMAL CONTROL — S303
- YES

BATTERY TEMPERATURE > Th4 ? — S304
- NO → INCREASE OUTPUT — S305
- YES

RESTRICT TAKEOFF AND LANDING — S306

RECOVERY CONTROL — S307
- REDUCE/STOP OUTPUT
- CHARGING / CHARGING-DISCHARGING
- RELAX RESTRAINT

OUTPUT — S308

END

# FIG. 12

```
        ╭─────────────────────╮
        │  RECOVERY CONTROL   │
        │       START         │
        ╰─────────────────────╯
                   │
                   ▼
        ┌─────────────────────┐ ──── S307A
        │     STOP OUTPUT     │
        └─────────────────────┘
                   │
                   ▼
        ┌─────────────────────┐ ──── S307B
        │ ADJUST THRUST AND LIFT │
        └─────────────────────┘
                   │
                   ▼
        ╭─────────────────────╮
        │        END          │
        ╰─────────────────────╯
```

# FIG. 13

```
                                                         15

 ┌──────┐ ┌──────┐ ┌──────┐ ┌──────┐ ┌──────┐ ┌──────┐
 │ BAT1 │ │ BAT2 │ │ BAT3 │ │ BAT4 │ │ BAT5 │ │ BAT6 │ ── 151
 └──┬───┘ └──┬───┘ └──┬───┘ └──┬───┘ └──┬───┘ └──┬───┘
    │        │        │        │        │        │
 ┌──┴────────┴────────┴────────┴────────┴────────┴──┐
 │                      CE                           │ ── 153
 └───────────────────────┬───────────────────────────┘
                         │
                 ┌───────┴───────┐
                 │      SB       │ ── 152
                 └───────────────┘
```

# FIG. 14

```
                                                         15

 ┌──────┐ ┌──────┐   ┌──────┐ ┌──────┐   ┌──────┐ ┌──────┐
 │ BAT1 │ │ BAT2 │   │ BAT3 │ │ BAT4 │   │ BAT5 │ │ BAT6 │ ── 151
 └──┬───┘ └──┬───┘   └──┬───┘ └──┬───┘   └──┬───┘ └──┬───┘
    │        │          │        │          │        │
 ┌──┴────────┴──┐    ┌──┴────────┴──┐    ┌──┴────────┴──┐
 │     CE1      │    │     CE2      │    │     CW3      │ ── 153
 └──────┬───────┘    └──────┬───────┘    └──────┬───────┘
        │                   │                   │
 ┌──────┴───────┐    ┌──────┴───────┐    ┌──────┴───────┐
 │     SB1      │    │     SB2      │    │     SB3      │ ── 152
 └──────────────┘    └──────────────┘    └──────────────┘
```

# FIG. 15

15

| BAT1 | BAT2 | BAT3 | BAT4 | BAT5 | BAT6 | 151 |
| CE1 | CE2 | CE3 | CE4 | CE5 | CE6 | 153 |
| SB1 | SB2 | SB3 | SB4 | SB5 | SB6 | 152 |

# FIG. 16

DEGREE OF TEMPORARY DETERIORATION

DISCHARGE CURRENT

NORMAL CONTROL — RECOVERY CONTROL — NORMAL CONTROL

TIME

# FIG. 17

| | ENERGIZATION ON/OFF | CURRENT ADJUSTMENT | POWER DISTRIBUTION | CHARGING-DISCHARGING |
|---|---|---|---|---|
| RELAY | ○ | | ○ | |
| RESISTANCE | | ○ | | |
| DC-DC CONVERTER | | ○ | | |
| BIDIRECTIONAL DC-DC CONVERTER | | ○ | | ○ |

# FIG. 18

# FIG. 19

# FIG. 20

EP 4 624 333 A1

## INTERNATIONAL SEARCH REPORT

| International application No. |
| --- |
| **PCT/JP2023/036828** |

### A. CLASSIFICATION OF SUBJECT MATTER

***B64D 27/24***(2024.01)i; ***B64U 50/30***(2023.01)i; ***H01M 10/44***(2006.01)i; ***H01M 10/48***(2006.01)i
FI:   B64D27/24; B64U50/30; H01M10/44 P; H01M10/48 P

According to International Patent Classification (IPC) or to both national classification and IPC

### B. FIELDS SEARCHED

Minimum documentation searched (classification system followed by classification symbols)

B64D27/24; B64U50/30; H01M10/44; H01M10/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 2022-44206 A (TOYOTA MOTOR CORP.) 17 March 2022 (2022-03-17) paragraphs [0002], [0019]-[0073], fig. 1-9 | 1, 5, 24 |
| Y | | 1-2, 4-6, 8-9, 11-13, 19-21, 23-25 |
| A | | 3, 7, 10, 14-18, 22 |
| Y | WO 2013/046263 A1 (TOYOTA MOTOR CORP.) 04 April 2013 (2013-04-04) paragraphs [0044], [0066] | 1-2, 4-6, 8-9, 11-13, 19-21, 23-25 |
| A | | 3, 7, 10, 14-18, 22 |
| Y | JP 2022-160214 A (MAZDA MOTOR CORP.) 19 October 2022 (2022-10-19) paragraph [0030] | 4 |
| A | | 3, 7, 10, 14-18, 22 |
| Y | JP 2018-190502 A (TOYOTA MOTOR CORP.) 29 November 2018 (2018-11-29) paragraphs [0031], [0060] | 6 |
| A | | 3, 7, 10, 14-18, 22 |

☑ Further documents are listed in the continuation of Box C.    ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **20 December 2023** | **09 January 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

# EP 4 624 333 A1

## INTERNATIONAL SEARCH REPORT

| | International application No. |
|---|---|
| | **PCT/JP2023/036828** |

### C.    DOCUMENTS CONSIDERED TO BE RELEVANT

| Category* | Citation of document, with indication, where appropriate, of the relevant passages | Relevant to claim No. |
|---|---|---|
| Y | JP 2013-46446 A (TOYOTA MOTOR CORP.) 04 March 2013 (2013-03-04) paragraphs [0125]-[0126], [0138], [0144] | 11-13, 19-21, 23, 25 |
| A | | 3, 7, 10, 14-18, 22 |
| A | US 2022/0115875 A1 (SAMSUNG ELECTRONICS CO., LTD.) 14 April 2022 (2022-04-14) | 1-25 |
| A | JP 2021-77450 A (TOYOTA MOTOR CORP.) 20 May 2021 (2021-05-20) | 9-23, 25 |
| A | JP 2015-106482 A (TOYOTA MOTOR CORP.) 08 June 2015 (2015-06-08) | 16 |

Form PCT/ISA/210 (second sheet) (January 2015)

**45**

## INTERNATIONAL SEARCH REPORT
### Information on patent family members

International application No.

**PCT/JP2023/036828**

| Patent document cited in search report | | | Publication date (day/month/year) | Patent family member(s) | | | Publication date (day/month/year) |
|---|---|---|---|---|---|---|---|
| JP | 2022-44206 | A | 17 March 2022 | (Family: none) | | | |
| WO | 2013/046263 | A1 | 04 April 2013 | US | 2014/0225571 | A1 | |
| | | | | paragraphs [0057], [0075] | | | |
| | | | | CN | 103827684 | A | |
| | | | | KR | 10-2014-0066729 | A | |
| JP | 2022-160214 | A | 19 October 2022 | (Family: none) | | | |
| JP | 2018-190502 | A | 29 November 2018 | (Family: none) | | | |
| JP | 2013-46446 | A | 04 March 2013 | (Family: none) | | | |
| US | 2022/0115875 | A1 | 14 April 2022 | EP | 3985829 | A1 | |
| | | | | KR | 10-2022-0048753 | A | |
| | | | | CN | 114362271 | A | |
| JP | 2021-77450 | A | 20 May 2021 | US | 2021/0132153 | A1 | |
| | | | | CN | 112825167 | A | |
| | | | | KR | 10-2021-0054467 | A | |
| JP | 2015-106482 | A | 08 June 2015 | (Family: none) | | | |

Form PCT/ISA/210 (patent family annex) (January 2015)

# EP 4 624 333 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2022188620 A
- JP 2020196440 A